# EUROPÄISCHE PATENTSCHRIFT

(11) **EP 3 447 847 B1**
(45) Veröffentlichungstag und Bekanntmachung des Hinweises auf die Patenterteilung: **24.02.2021**
(21) Anmeldenummer: 18190460.8
(22) Anmeldetag: 23.08.2018
(51) Int. Cl.: H01R 12/70, H05K 1/02, H01R 13/6587, H01R 13/518, H01R 12/72, H05K 1/11

(54) **VERBINDERELEMENT UND VERBINDERSYSTEM ZUM VERBINDEN EINER PCB-KARTE MIT EINEM ZENTRALRECHNER EINES KRAFTFAHRZEUGS**
CONNECTOR ELEMENT AND CONNECTOR SYSTEM FOR CONNECTING A PCB CARD WITH A CENTRAL COMPUTER OF A MOTOR VEHICLE
ÉLÉMENT DE RACCORDEMENT ET SYSTÈME DE RACCORDEMENT PERMETTANT DE RACCORDER UNE CARTE DE CIRCUIT IMPRIMÉ À UN ORDINATEUR CENTRAL D'UN VÉHICULE AUTOMOBILE

(30) Priorität: 25.08.2017 DE 102017008087; 25.08.2017 DE 102017008065
(43) Veröffentlichungstag der Anmeldung: 27.02.2019
(73) Patentinhaber: Yamaichi Electronics Deutschland GmbH, 85609 Aschheim-Dornach (DE)
(72) Erfinder: QUITER, Michael, 57482 Wenden (DE); SERRANO, Jaime Fernández, 80796 München (DE); MICHEL, Dirk, 85778 Haimhausen (DE)
(74) Vertreter: Müller-Boré & Partner Patentanwälte PartG mbB

(56) Entgegenhaltungen:
- US-A1- 2010 184 339
- US-B2- 8 662 923

## Beschreibung

Die Erfindung betrifft ein kartenseitiges Verbinderelement für ein Verbindersystem zum Verbinden einer PCB-Karte mit einem Zentralrechner eines Kraftfahrzeugs. Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer PCB (Printed Circuit Board) Karte bzw. einer Chipkarte verbunden werden, die für die jeweilige Anwendung spezifisch ist. Es ist daher erforderlich, ein für den Automotive Bereich geeignetes Verbindersystem zwischen einer PCB-Karte und dem Zentralrechner eines Kraftfahrzeugs bereitzustellen.

Im Stand der Technik existieren Netzwerkstecker bzw. Netzwerkverbinder aus dem Bereich der Telekommunikation, die jedoch nicht für den Automotive Bereich konzipiert bzw. geeignet sind. Weiterhin existieren hochpolige Verbinder, die eine Vielzahl von einzelnen Blechen zur Schirmung der Kontaktelemente aufweisen. Solche Verbinder sind jedoch nicht massentauglich und bereits aus diesem Grund nicht für den Automotive Bereich geeignet. Die Druckschrift US 8 662 923 B2 offenbart z.B. ein elektrisches Verbindersystem mit einem Stecker und einen Sockel, wobei der Stecker ein elektrisch isolierendes Gehäuse aufweist. Ferner umfasst der Stecker elektrische Anschlüsse, welche Zwischenräume aufweisen. Über die Zwischenräume kann die bei hohen Strömen entstandene Wärme an die Atmosphäre abgegeben werden. Die Druckschrift US 2010/184339 A1 offenbart einen Steckdosen-Leistungsverbinder, der eine erste und eine zweite Reihe elektrischer Leistungskontakte aufweist, die in einem Verbindergehäuse angeordnet sind.

Es ist eine Aufgabe der vorliegenden Erfindung, ein kartenseitiges Verbinderelement für ein Verbindersystem zum Verbinden einer PCB-Karte mit einem Zentralrechner eines Kraftfahrzeugs bereitzustellen, welches den Anforderungen im Automotive Bereich, insbesondere hinsichtlich Stabilität, Wärmeentwicklung, Signalgüte, Frequenzbereich der Signalübertragung und Layout der PCB-Karte, genügt. Diese Aufgabe wird durch den Gegenstand von unabhängigem Anspruch 1 gelöst. Vorteilhafte Ausführungsformen sind Gegenstand der Unteransprüche.

Ein unabhängiger Aspekt zur Lösung der Aufgabe betrifft ein kartenseitiges Verbinderelement nach Anspruch 1.

Kühlrippen im Sinne dieser Erfindung sind Elemente, insbesondere Kühlelemente oder Kühlkörper, zur Vergrößerung der Oberfläche des kartenseitigen Gehäuses, um die Wärmeübertragung an die Umgebung und damit die Kühlung zu verbessern. Die Kühlrippen können dafür sorgen, dass eine zulässige Betriebstemperatur von elektronischen Bauteilen (hier z.B. die Kontaktelemente des Verbindersystems und/oder Bauteile und Leitungen auf der PCB-Karte) eingehalten wird.

Mit dem Begriff "Verbinden" wird im Rahmen dieser Beschreibung in erster Linie ein mechanisches und/oder ein wärmeleitfähiges bzw. thermisches Verbinden verstanden. Unter einem "mechanischen Verbinden" wird insbesondere ein Befestigen bzw. Fixieren und vorzugsweise ein (unter normalen Umständen bzw. Bedingungen) nicht lösbares Befestigen bzw. Fixieren verstanden, welches z.B. durch ein Verlöten erreicht werden kann. Unter einem "wärmeleitfähigen Verbinden" bzw. "thermischen Verbinden" wird insbesondere verstanden, dass zwei Elemente, welche wärmeleitfähig oder thermisch miteinander verbunden sind, wechselseitig Wärme bzw. thermische Energie austauschen können. Im Falle von unterschiedlichen Temperaturen der beiden Elemente führt eine wärmeleitfähige Verbindung somit zu einer Kühlung des Elements mit der höheren Temperatur. Mit anderen Worten bedeutet ein "wärmeleitfähiges Verbinden" zweier Elemente im Sinne dieser Beschreibung ein Verbinden dieser Elemente derart, dass Wärme zwischen den Elementen ausgetauscht werden kann und/oder dass sich die Temperaturen dieser Elemente angleichen können, insbesondere so, dass eine maximal zulässige Betriebstemperatur der Elemente (hier z.B. des KFZ-Zentralrechners, des Verbindersystems und/oder der PCB-Karte) eingehalten wird.

Zumindest eine Teilmenge der Kühlrippen ist vorgesehen und ausgelegt, um das kartenseitige Gehäuse mit der PCB-Karte sowohl mechanisch als auch thermisch bzw. wärmeleitfähig zu verbinden. Im Rahmen der vorliegenden Erfindung hat sich herausgestellt, dass ein mechanisches und wärmeleitfähiges Verbinden zwischen dem kartenseitigen Gehäuse und der PCB-Karte insbesondere dadurch erreicht wird, dass das kartenseitige Gehäuse samt Kühlrippen aus Zinkdruckguss ausgebildet wird. Zinkdruckguss eignet sich auf Grund der guten Wärmeleiteigenschaften und auf Grund seiner Stabilität bzw. Festigkeit hervorragend als Material für das kartenseitige Gehäuse und die Kühlrippen. Auch das rechnerseitige Gehäuse kann vorteilhafterweise aus Zinkdruckguss ausgebildet sein.

Insbesondere im Zusammenhang mit Kontaktelementen des Verbindersystems kann unter dem Begriff "Verbinden" alternativ oder zusätzlich auch ein elektrisches Verbinden verstanden werden.

Unter einem "rechnerseitigen Verbinderelement" wird ein Verbinderelement verstanden, welches ausgelegt ist, um unmittelbar an einen Zentralrechner angeschlossen zu werden. Entsprechend wird unter einem "kartenseitigen Verbinderelement" ein Verbinderelement verstanden, welches ausgelegt ist, um unmittelbar an eine PCB-Karte angeschlossen zu werden. Allgemein deutet die Zusatzbezeichnung "rechnerseitig" bei verschiedenen Elementen an, dass diese Elemente zu dem rechnerseitigen Verbinderelement gehören. Entsprechend deutet die Zusatzbezeichnung "kartenseitig" bei verschiedenen Elementen an, dass diese Elemente zu dem kartenseitigen Verbinderelement gehören.

Eine PCB-Karte kann z.B. eine PCMCIA Express 3.0 bzw. 4.0 Karte sein. Es versteht sich, dass mit "PCB-Karte" auch sämtliche andere Chipkarten umfasst sind, welche insbesondere für die Verwendung im Automotive Bereich geeignet sind.

Das erfindungsgemäße Verbindersystem und insbesondere das erfindungsgemäße kartenseitge Verbinderelement haben mit Hilfe der Kühlrippen, welche vorgesehen und ausgelegt sind, um das kartenseitige Gehäuse mit der PCB-Karte mechanisch zu verbinden, einerseits eine Kühlfunktion, um vorteilhafterweise eine maximal zulässige Betriebstemperatur von elektronischen Bauteilen einzuhalten, und können andererseits in platzsparender Weise mechanisch stabil mit der PCB-Karte verbunden bzw. an diese fixiert werden. Somit kann neben der Kühlfunktion auch eine ausreichende mechanische Stabilität bezüglich Scherkräften beim Stecken und/oder Verschrauben sowie im Hinblick auf Vibrationen gewährleistet werden.

Im Rahmen der vorliegenden Erfindung hat sich gezeigt, dass das erfindungsgemäße Verbindersystem und insbesondere das erfindungsgemäße kartenseitge Verbinderelement den Anforderungen im Automotive Bereich genügen. Zudem können die Verbinderelemente und somit das Verbindersystem schnell und einfach hergestellt werden, so dass sie im Vergleich zu herkömmlichen Verbindern, die den Anforderungen im Automotive Bereich genügen, auch massentauglich sind.

In einer bevorzugten Ausführungsform ragt zumindest eine Teilmenge der Kühlrippen über einen steckseitigen Rand bzw. eine steckseitige Fläche des kartenseitigen Gehäuses hinaus. Insbesondere ragen die Kühlrippen, welche vorgesehen und ausgelegt sind, um das kartenseitige Gehäuse mit der PCB-Karte mechanisch zu verbinden, bzw. Endabschnitte dieser Kühlrippen, über einen steckseitigen Rand bzw. eine steckseitige Fläche des kartenseitigen Gehäuses hinaus. Dadurch können diese Kühlrippen, und somit auch das kartenseitige Gehäuse, mit der PCB-Karte mechanisch, und insbesondere auch wärmeleitfähig, verbunden werden. Vorzugsweise beträgt die über den steckseitigen Rand hinausragende Länge der Kühlrippenendabschnitte etwa 2 mm.

In einer weiteren bevorzugten Ausführungsform sind die Kühlrippen derart angeordnet, dass jeweils eine Längsachse der Kühlrippen senkrecht zu einer Längsachse des kartenseitigen Verbinderelements ausgerichtet ist.

In einer weiteren bevorzugten Ausführungsform umfasst die Mehrzahl von Kühlrippen zumindest eine Kühlrippe erster Art und zumindest eine Kühlrippe zweiter Art, wobei die Kühlrippe zweiter Art im Vergleich zur Kühlrippe erster Art vorzugsweise eine größere Länge aufweist.

Die zumindest eine Kühlrippe zweiter Art kann z.B. eine um etwa 2 mm größere Länge als die zumindest eine Kühlrippe erster Art aufweisen.

Die Begriffe "Kühlrippe erster Art" und "Kühlrippe zweiter Art" werden im Rahmen dieser Beschreibung verwendet, um zu definieren, dass es sich um zwei, insbesondere funktional, verschiedene Kühlrippen handelt. Während die Kühlrippe erster Art lediglich eine Kühl- bzw. Wärmeableitfunktion hat, weist die Kühlrippe zweiter Art neben dieser Kühlfunktion zusätzlich eine Stabilisierungsfunktion, eine Verbindungsfunktion und/oder eine Befestigungsfunktion auf. Daher wird im Rahmen dieser Beschreibung die "Kühlrippe erster Art" auch als "Standardkühlrippe" und die "Kühlrippe zweiter Art" auch als "PCB-Verbindungskühlrippe" bezeichnet. Die Kühlrippe zweiter Art unterscheidet sich von der Kühlrippe erster Art vorzugsweise in der Länge und/oder auch dadurch, dass sie eine größere Dicke, einen größeren Durchmesser und/oder ein größeres Volumen hat und somit stabiler ausgebildet ist. Beispielsweise beträgt das Volumen einer Kühlrippe erster Art etwa 25% des Volumens einer Kühlrippe zweiter Art. Die Kühlrippe zweiter Art kann sich von der Kühlrippe erster Art auch in der Form unterscheiden. Beispielsweise kann die Kühlrippe zweiter Art zylinderförmig oder säulenförmig ausgebildet sein, während die Kühlrippe erster Art quaderförmig ausgebildet sein kann. Die Kühlrippe zweiter Art ist insbesondere als ein PCB-Verbindungselement, PCB-Befestigungselement und/oder als PCB-Eingriffselement ausgebildet. Mit anderen Worten ist die Kühlrippe zweiter Art vorgesehen, ausgelegt und angeordnet, um mit der PCB-Karte verbunden zu werden, um an die PCB-Karte befestigt zu werden und/oder um mit der PCB-Karte in Eingriff gebracht zu werden. Somit wird im Rahmen dieser Beschreibung mit der Kühlrippe zweiter Art eine Kühlrippe verstanden, die im Vergleich zur Kühlrippe erster Art nicht nur ein Kühlelement, sondern zugleich auch noch ein Verbindungselement, Befestigungselement und/oder Eingriffselement zum Verbinden des kartenseitigen Gehäuses mit der PCB-Karte und/oder zum Befestigen des kartenseitigen Gehäuses an die PCB-Karte darstellt.

Die Kühlrippen zweiter Art entsprechen somit denjenigen Kühlrippen, welche vorgesehen und ausgelegt sind, um das kartenseitige Gehäuse mit der PCB-Karte mechanisch, und insbesondere auch wärmeleitfähig, zu verbinden. Es ist möglich, dass das kartenseitige Gehäuse ausschließlich solche Kühlrippen zweiter Art aufweist. Vorzugsweise weist das kartenseitige Gehäuse aber auch noch andere Kühlrippen, nämlich zumindest eine Kühlrippe erster Art auf, so dass nur eine Teilmenge der Kühlrippen des kartenseitigen Gehäuses vorgesehen und ausgelegt ist, um das kartenseitige Gehäuse mit der PCB-Karte mechanisch, und insbesondere auch wärmeleitfähig, zu verbinden.

Im folgenden werden der Einfachheit halber diejenigen Kühlrippen, welche vorgesehen und ausgelegt sind, um das kartenseitige Gehäuse mit der PCB-Karte mechanisch, und insbesondere auch wärmeleitfähig, zu verbinden, als Kühlrippen zweiter Art oder als PCB-Verbindungskühlrippen bezeichnet, während alle übrigen Kühlrippen als Kühlrippen erster Art oder als Standardkühlrippen bezeichnet werden.

Die zumindest eine Kühlrippe zweiter Art ist ausgelegt und angeordnet, um das kartenseitige Gehäuse mit der PCB-Karte mechanisch und wärmeleitfähig zu verbinden. Insbesondere ist die zumindest eine Kühlrippe zweiter Art ausgelegt und angeordnet, um mit der PCB-Karte verlötet zu werden, beispielsweise mittels eines Reflow-Lötens. Vorzugsweise weist die zumindest eine Kühlrippe zweiter Art einen Endabschnitt auf, der in eine zugehörigen Ausnehmung bzw. ein zugehöriges Loch der PCB-Karte gesteckt und anschließend verlötet werden kann. Mit anderen Worten kann die zumindest eine Kühlrippe zweiter Art bzw. ein Endabschnitt davon mit der PCB-Karte, insbesondere mit einem auf der PCB-Karte vorgesehenem Loch, in Eingriff gebracht werden. Mit Hilfe der Kühlrippen zweiter Art kann das kartenseitige Gehäuse somit nicht nur mechanisch an die PCB-Karte fixiert werden, sondern vorteilhafterweise auch wärmeleitfähig mit der PCB-Karte verbunden werden. Das Verlöten der Kühlrippen zweiter Art mit der PCB-Karte sorgt zusätzlich für eine noch bessere Stabilität und eine noch bessere Kühlung.

In einer weiteren bevorzugten Ausführungsform weist das kartenseitige Gehäuse zumindest zwei Kühlrippen zweiter Art auf. Zudem ist zwischen zwei benachbarten Kühlrippen zweiter Art jeweils eine Kühlrippe erster Art angeordnet. Dies führt vorteilhafterweise dazu, dass einerseits noch ausreichend Stabilität für die Verbindung des kartenseitigen Verbinderelements mit der PCB-Karte gewährleistet ist, insbesondere im Hinblick auf die im KFZ auftretenden Vibrationen, und andererseits auch die Kühleigenschaften des Verbinders gewährleistet werden können. Ein weiterer Vorteil dieser Ausführungsform liegt darin, dass zwischen den Kühlrippen zweiter Art, welche im montierten Zustand mit der PCB-Karte mechanisch verbunden sind, ausreichend Raum für elektrische Leitungen bzw. Leiterbahnen auf der PCB-Karte, d.h. eine sogenannte Routinggasse, geschaffen wird. Eine solche Routinggasse kann insbesondere erforderlich sein, um Kontakte bzw. Leiterbahnen der PCB-Karte mit Kontaktelementen, insbesondere Differential-Pair Kontaktelementen, des kartenseitigen Verbinderelements, und damit wiederum über entsprechende Kontaktelemente des rechnerseitigen Verbinderelements mit dem KFZ-Zentralrechner, zu verbinden.

Unter einem montierten Zustand wird im Sinne der vorliegenden Beschreibung ein Zustand verstanden, in dem das Verbindersystem bzw. das rechnerseitige und das kartenseitige Verbinderelement bestimmungsgemäß verwendet wird bzw. werden und/oder bestimmungsgemäß montiert, zusammengesetzt oder zusammengesteckt ist bzw. sind. Insbesondere wird unter einem montierten Zustand verstanden, dass das rechnerseitige und kartenseitige Verbinderelement miteinander verbunden sind. Ein montierter Zustand kann daher auch als zusammengebauter Zustand, zusammengesetzter Zustand, zusammengesteckter Zustand und/oder als Betriebszustand bezeichnet werden. Mit anderen Worten bezeichnet der montierte Zustand eines Verbinderelements bzw. Verbindersystems eine bestimmungsgemäße Anordnung oder Einbauposition der einzelnen Elemente des Verbinderelements bzw. Verbindersystems.

In einer weiteren bevorzugten Ausführungsform weist das kartenseitige Verbinderelement eine Anzahl N von in einer Reihe angeordneten kartenseitigen Differential-Pair Kontaktelementpaaren auf, wobei die Anzahl an Kühlrippen zweiter Art der Anzahl N entspricht. Dabei erstreckt sich die Reihe, in der die N kartenseitigen Differential-Pair Kontaktelementpaare angeordnet sind, entlang einer Längsachse des kartenseitigen Verbinderelements. Eine Reihe im Sinne dieser Beschreibung erstreckt sich somit senkrecht zur ersten und zweiten Montagerichtung.

Differential-Pair Kontaktelemente sind Kontaktelemente, welche für eine symmetrische oder differentielle Signalübertragung, d.h. zum Übertragen von Differenzsignalen, verwendet werden. Eine symmetrische Signalübertragung ist ein Verfahren, um Signale auch bei längeren Übertragungswegen möglichst tolerant gegenüber Störeinstrahlungen übermitteln zu können. Die Übertragung erfolgt dabei statt mit nur einem einzigen Signalleiter mit einem Paar gleichartiger Signalleiter, also mit Hilfe eines Differential-Pair Kontaktelementpaares. Dabei wird auf der einen Leitung das eigentliche Signal und auf der anderen Leitung ein dem Empfänger bekanntes Referenzsignal, insbesondere das um 180° phasenverdrehte Signal, übertragen. Die Beeinflussung des Nutzsignals durch Einkopplungen auf dem Übertragungsweg ist auf beiden Leitern nahezu gleichartig, wenn sie die gleiche Quellimpedanz, gleiche Leitungsimpedanz und gleiche Lastimpedanz aufweisen. Bei Differenzbildung der beiden Leiter-Potenziale hebt sich die Störung dann nahezu auf.

Im Rahmen der vorliegenden Erfindung hat sich herausgestellt, dass es für Automotive Anwendungen hinsichtlich der erforderlichen Übertragungsqualität und der Frequenzbereiche vorteilhaft ist, eine symmetrische Signalübertragung mit Hilfe von Differential-Pair Kontaktelementen bereitzustellen, und dass es im Hinblick auf die mechanische Stabilität und die Wärmeentwicklung des Verbinders, sowie im Hinblick auf das Layout der PCB-Karten insbesondere von Vorteil ist, wenn die Anzahl an Kühlrippen zweiter Art der Anzahl N an kartenseitigen Differential-Pair Kontaktelementpaaren entspricht.

In einer weiteren bevorzugten Ausführungsform ist das rechnerseitige Verbinderelement ausgelegt, um entlang einer ersten Montagerichtung mit dem Zentralrechner verbunden, insbesondere zusammengesteckt, zu werden. Das kartenseitige Verbinderelement ist ausgelegt, um entlang einer zweiten Montagerichtung mit der PCB-Karte verbunden, insbesondere zusammengesteckt, zu werden. Ferner sind das rechnerseitige Verbinderelement und das kartenseitige Verbinderelement entlang der ersten Montagerichtung verbindbar bzw. zusammensteckbar. Vorzugsweise unterscheidet sich die erste Montagerichtung von der zweiten Montagerichtung. Insbesondere ist die erste Montagerichtung im Wesentlichen senkrecht zur zweiten Montagerichtung.

In einer weiteren bevorzugten Ausführungsform sind die Kühlrippen, und insbesondere die zumindest eine Kühlrippe zweiter Art, derart angeordnet, dass jeweils eine Längsachse der Kühlrippen entlang der zweiten Montagerichtung ausgerichtet ist.

In einer weiteren bevorzugten Ausführungsform ist die zumindest eine Kühlrippe zweiter Art derart angeordnet, dass eine Längsachse der zumindest einen Kühlrippe zweiter Art eine Gerade schneidet, welche sich zwischen den Kontaktelementen eines Differential-Pair Kontaktelementpaares des kartenseitigen Verbinderelements befindet und entlang der ersten Montagerichtung ausgerichtet ist. Die Erfinder haben erkannt, dass somit in effizienter Weise eine Routinggasse, wie weiter oben beschrieben, bereitgestellt werden kann.

In einer weiteren bevorzugten Ausführungsform ist das kartenseitige Gehäuse zweiteilig ausgebildet. Vorzugsweise weist das kartenseitige Gehäuse ein erstes kartenseitiges Gehäuseelement mit zumindest einem ersten Eingriff- bzw. Fixierelement und ein zweites kartenseitiges Gehäuseelement mit zumindest einem zweiten Eingriff- bzw. Fixierelement auf. Das zumindest eine erste Fixierelement ist als eine Aussparung des ersten Gehäuseelements ausgebildet, während das zumindest eine zweite Fixierelement als eine Aussparung des zweiten Gehäuseelements ausgebildet ist. Mit Hilfe zumindest eines dritten Fixierelements, welches in die oben genannten Aussparungen (d.h. in das zumindest eine erste und das zumindest eine zweite Fixierelement) eingreift, können das erste kartenseitige Gehäuseelement und das zweite kartenseitige Gehäuseelement miteinander verbunden bzw. zusammengesteckt werden. Vorzugsweise weist das kartenseitge Verbinderelement jeweils zwei erste, zwei zweite und zwei dritte Fixierelemente auf. Insbesondere können mit Hilfe der Fixierelemente das erste kartenseitige Gehäuseelement und das zweite kartenseitige Gehäuseelement zueinander in Position gehalten werden. Dies ist insbesondere für ein Verlöten des kartenseitigen Verbinderelements hilfreich.

In einer weiteren bevorzugten Ausführungsform weist das kartenseitige Gehäuse zumindest ein Führungselement und das rechnerseitige Gehäuse zumindest ein komplementäres Führungselement auf. Das Führungselement kann z.B. einen Führungsvorsprung oder eine Führungsnut umfassen, während das komplementäre Führungselement entsprechend eine Führungsnut oder einen Führungsvorsprung umfassen kann. Das zumindest eine Führungselement des kartenseitigen Gehäuses kann mit dem komplementären Führungselement des rechnerseitigen Verbinderelements in Eingriff gebracht werden. Insbesondere stehen die Führungselemente im montierten Zustand miteinander in Eingriff. Mit Hilfe der Führungselemente kann die Montage des Verbindersystems erleichtert werden. Vorzugsweise weist das erste kartenseitige Gehäuseelement das zumindest eine Führungselement auf, während das zweite kartenseitige Gehäuseelement die Kühlrippen aufweist. Eine derartige Anordnung hat sich im Rahmen dieser Erfindung hinsichtlich Funktionalität, Platzbedarf und Massentauglichkeit als besonders vorteilhaft herausgestellt.

In einer weiteren bevorzugten Ausführungsform weist das Verbindersystem ferner die PCB-Karte auf. Weiter vorzugsweise ist die zumindest eine Kühlrippe zweiter Art im montierten Zustand mit der PCB-Karte verbunden und/oder an die PCB-Karte befestigt, und insbesondere mit der PCB-Karte verlötet. Insbesondere weist die PCB-Karte dazu entsprechende Verbindungsmittel, z.B. Bohrungen bzw. Löcher auf.

In einer weiteren bevorzugten Ausführungsform weist das rechnerseitige Verbinderelement eines oder mehrere der folgenden Komponenten auf:
- ein rechnerseitiges Gehäuse mit zumindest einem rechnerseitigen Kontakthohlraum;
- zumindest einen rechnerseitigen Isolierkörper, welcher im montierten Zustand innerhalb des zumindest einen rechnerseitigen Kontakthohlraums angeordnet ist;
- eine Vielzahl von rechnerseitigen Kontaktelementen, welche im montierten Zustand zumindest bereichsweise innerhalb von rechnerseitigen Isolierhohlräumen in dem zumindest einen rechnerseitigen Isolierkörper angeordnet sind.

Das kartenseitige Verbinderelement weist vorzugsweise ferner eines oder mehrere der folgenden Komponenten auf:
- zumindest einen kartenseitiger Isolierkörper, welcher im montierten Zustand innerhalb des zumindest einen kartenseitigen Kontakthohlraums angeordnet ist und kartenseitige Isolierhohlräume aufweist, die ausgelegt sind, um im montierten Zustand die rechnerseitigen Kontaktelemente zumindest bereichsweise aufzunehmen;
- eine Vielzahl von kartenseitigen Kontaktelementen, welche im montierten Zustand zumindest bereichsweise innerhalb der kartenseitigen Isolierhohlräume angeordnet sind und die rechnerseitigen Kontaktelemente elektrisch kontaktieren.

Das kartenseitige Gehäuse weist vorzugsweise zumindest einen kartenseitigen Kontakthohlraum auf.

Wie bereits weiter oben erwähnt, sind das rechnerseitige und kartenseitige Gehäuse, und damit auch die Kühlrippen erster und zweiter Art, vorzugsweise aus Zinkdruckguss ausgebildet bzw. gefertigt. Vorzugsweise ist das Zinkdruckguss-Material ein EZDA3 (Zinc Die Casting Alloy) und insbesondere eine in der Norm EN 12844 beschriebene ZP0410-, ZP0400- und/oder ZPO430-Legierung. Es versteht sich, dass aber auch alternative Zinkdruckguss-Materialien verwendet werden können. Insbesondere ist das rechnerseitige Zinkdruckguss-Gehäuse einstückig ausgebildet, d.h. es ist nicht aus mehreren Teilen zusammengesetzt, sondern umfasst lediglich ein einziges Teil aus einem Zinndruckguss-Material. Die rechnerseitigen Kontakthohlräume sind vorzugsweise in Form einer Matrix angeordnet. Das rechnerseitige und kartenseitige Zinkdruckguss-Gehäuse haben vorteilhafterweise eine Schirmwirkung und sorgen somit für eine hohe Signalqualität.

Das rechnerseitige Verbinderelement kann ferner eine Vielzahl von rechnerseitigen hohlförmigen Isolierkörpern aufweisen, welche im montierten Zustand innerhalb der rechnerseitigen Kontakthohlräume angeordnet sind. Vorzugsweise sind die rechnerseitigen Isolierkörper aus den Materialien PA9T, PA10T oder LCP ausgebildet bzw. gefertigt. Die Anzahl der rechnerseitigen Isolierkörper entspricht vorzugsweise der Anzahl an rechnerseitigen Kontakthohlräumen. Die rechnerseitigen Isolierkörper sind vorzugsweise rechteckförmig ausgebildet.

Zusätzlich kann das rechnerseitige Verbinderelement eine Vielzahl von rechnerseitigen Kontaktelementen, insbesondere Kontaktstifte, aufweisen. Vorzugsweise sind die rechnerseitigen Kontaktelemente aus CuSn6 oder alternativen Kupferlegierungen ausgebildet bzw. gefertigt. Als Kontaktelement werden allgemein elektrische Leiter verstanden, mit denen elektrische Signale übertragen werden können. Die rechnerseitigen Kontaktelemente können im montierten Zustand zumindest bereichsweise innerhalb von rechnerseitigen Isolierhohlräumen der rechnerseitigen Isolierkörper, und damit auch innerhalb der rechnerseitigen Kontakthohlräume, angeordnet sein. Mit anderen Worten können die rechnerseitigen Isolierkörper die rechnerseitigen Kontaktelemente zumindest bereichsweise umgeben. "Zumindest bereichsweise" bedeutet in diesem Zusammenhang, dass jeweils zumindest ein Abschnitt eines rechnerseitigen Kontaktelements innerhalb eines rechnerseitigen Isolierhohlraums eines rechnerseitigen Isolierkörpers angeordnet ist bzw. dass ein rechnerseitiger Isolierkörper zumindest einen Abschnitt eines rechnerseitigen Kontaktelements umgibt. Insbesondere sind die rechnerseitigen Kontaktelemente im montierten Zustand zumindest bereichsweise innerhalb von rechnerseitigen Isolierhohlräumen der rechnerseitigen Isolierkörper angeordnet, so dass sie gegenüber dem rechnerseitigen Gehäuse elektrisch isoliert sind. Die rechnerseitigen Kontaktelemente können das rechnerseitige Gehäuse im Wesentlichen vollständig durchdringen.

Abgesehen von der isolierenden Wirkung dienen die rechnerseitigen Isolierkörper auch dazu, die rechnerseitigen Kontaktelemente in den rechnerseitigen Kontakthohlräumen zu halten bzw. zu befestigen. Die Isolierkörper haben somit neben ihrer Isolierfunktion auch eine Stabilitätsfunktion, d.h. eine Halte- bzw. Befestigungsfunktion. An den Stellen bzw. Abschnitten der Kontaktelemente, die nicht von einem Isolierkörper umgeben sind, kann Luft als Isolator dienen.

Ein Steckende der rechnerseitigen Kontaktelemente kann aus dem rechnerseitigen Gehäuse herausragen und zum Kontaktieren des Zentralrechners ausgebildet sein.

Das kartenseitige Verbinderelement weist vorzugsweise ein kartenseitiges Zinkdruckguss-Gehäuse mit zumindest einem oder einer Vielzahl von kartenseitigen Kontakthohlräumen, und damit zumindest einer oder einer Vielzahl von kartenseitigen Kontaktöffnungen, auf. Der (oder die) kartenseitige(n) Kontakthohlraum(-räume) sind als Aussparung im kartenseitigen Gehäuse ausgebildet. Jeder kartenseitige Kontakthohlraum bildet eine kartenseitige Kontaktöffnung aus.

Das kartenseitige Gehäuse ist vorzugsweise zweistückig ausgebildet, d.h. es kann aus genau zwei Teilen, nämlich einem ersten kartenseitigen Gehäuseelement und einem zweiten kartenseitigen Gehäuseelement, vorzugsweise jeweils aus Zinkdruckguss, zusammengesetzt sein. Dabei weist insbesondere das zweite kartenseitige Gehäuseelement die Kühlrippen auf. Die kartenseitigen Kontakthohlräume sind vorzugsweise in Form einer Matrix und insbesondere komplementär zu den rechnerseitigen Kontakthohlräumen angeordnet. Mit anderen Worten gibt es zu jedem rechnerseitigen Kontakthohlraum einen zugehörigen bzw. komplementären kartenseitigen Kontakthohlraum.

Das kartenseitige Verbinderelement kann ferner eine Vielzahl von hohlförmigen kartenseitigen Isolierkörpern aufweisen, welche im montierten Zustand innerhalb der kartenseitigen Kontakthohlräume angeordnet sind. Vorzugsweise sind die kartenseitigen Isolierkörper aus den Materialien PA9T, PA10T oder LCP ausgebildet bzw. gefertigt. Die kartenseitigen Isolierkörper können kartenseitige Isolierhohlräume aufweisen, die ausgelegt sind, um im montierten Zustand die rechnerseitigen Kontaktelemente zumindest bereichsweise aufzunehmen. Mit anderen Worten können im montierten Zustand die rechnerseitigen Kontaktelemente in den kartenseitigen Isolierkörper eindringen, um die kartenseitigen Kontaktelemente zu kontaktieren. Die Anzahl der kartenseitigen Isolierkörper entspricht vorzugsweise der Anzahl von kartenseitigen Kontakthohlräumen. Weiter vorzugsweise entspricht die Anzahl von rechnerseitigen Kontakthohlräumen der Anzahl von kartenseitigen Kontakthohlräumen. Die kartenseitigen Isolierkörper sind vorzugsweise rechteckförmig ausgebildet.

Zusätzlich kann das kartenseitige Verbinderelement eine Vielzahl von kartenseitigen Kontaktelementen aufweisen. Vorzugsweise sind die kartenseitigen Kontaktelemente aus CuSn6 oder alternativen Kupferlegierungen ausgebildet bzw. gefertigt. Die kartenseitigen Kontaktelemente können im montierten Zustand zumindest bereichsweise innerhalb von kartenseitigen Isolierhohlräumen der kartenseitigen Isolierkörper, und damit auch innerhalb der kartenseitigen Kontakthohlräume, angeordnet sein. Mit anderen Worten können die kartenseitigen Isolierkörper die kartenseitigen Kontaktelemente zumindest bereichsweise umgeben. Der Begriff "zumindest bereichsweise" bedeutet in diesem Zusammenhang, dass jeweils zumindest ein Abschnitt eines kartenseitigen Kontaktelements innerhalb eines kartenseitigen Isolierhohlraums eines kartenseitigen Isolierkörpers angeordnet ist bzw. dass ein kartenseitiger Isolierkörper zumindest einen Abschnitt eines kartenseitigen Kontaktelements umgibt. Insbesondere sind die kartenseitigen Kontaktelemente im montierten Zustand zumindest bereichsweise innerhalb von kartenseitigen Isolierhohlräumen der kartenseitigen Isolierkörper angeordnet, so dass sie gegenüber dem kartenseitigen Gehäuse elektrisch isoliert sind. Die kartenseitigen Kontaktelemente sind vorzugsweise derart ausgelegt und angeordnet, dass sie im montierten Zustand jeweils zugehörige rechnerseitige Kontaktelemente kontaktieren. Die Kontaktierung der rechnerseitigen und kartenseitigen Kontaktelemente erfolgt insbesondere innerhalb der kartenseitigen Kontakthohlräume bzw. innerhalb der kartenseitigen Isolierkörper.

Ein Steckende der kartenseitigen Kontaktelemente kann aus dem kartenseitigen Gehäuse herausragen und zum Kontaktieren der PCB-Karte ausgebildet sein.

Abgesehen von der isolierenden Wirkung dienen die kartenseitigen Isolierkörper auch dazu, die kartenseitigen Kontaktelemente in den kartenseitigen Kontakthohlräumen zu halten bzw. zu befestigen. Die kartenseitigen Isolierkörper haben also sowohl eine Isolierfunktion als auch eine Stabilitätsfunktion. An den Stellen bzw. Abschnitten der kartenseitigen Kontaktelemente, die nicht von einem kartenseitigen Isolierkörper umgeben sind, kann Luft als Isolator dienen.

Weist das rechnerseitige Verbinderelement und das kartenseitige Verbinderelement jeweils ein Zinkdruckguss-Gehäuse mit Kontakthohlräumen auf, kann der vorteilhafte synergetische Effekt erzielt werden, dass im montierten Zustand eine durchgängige Abschirmwirkung auf Grund der von den Zinkdruckguss-Gehäusen umgebenen Hohlräumen, in welchen sich die signalübertragenden Kontaktelemente befinden, erreicht wird.

Vorzugsweise greifen im montierten Zustand Endabschnitte von zumindest einem Teil der Vielzahl von rechnerseitigen Kontakthohlräumen in komplementäre Endabschnitte von zumindest einem Teil der Vielzahl von kartenseitigen Kontakthohlräumen ein. Alternativ oder zusätzlich weist das rechnerseitige Gehäuse zumindest ein Eingriffelement auf, welches im montierten Zustand in zumindest ein komplementäres Eingriffelement des kartenseitigen Gehäuses eingreift. Das Eingriffelment kann z.B. ein Vorsprung sein und das komplementäre Eingriffelement eine zugehörige Öffnung. Auf diese Weise wird eine stabile und zugleich kontinuierliche bzw. durchgehende Verbindung der rechnerseitigen und kartenseitigen Kontakthohlräume geschaffen bzw. unterstützt. Dies bewirkt vorteilhafterweise eine hohe Stabilität sowie gleichzeitig eine durchgehende Schirmwirkung. Die Qualität der Signalübertragung zwischen der PCB-Karte und dem Zentralrechner kann dadurch erhöht werden und genügt insbesondere den Anforderungen im Automotive Bereich.

Weiter vorzugsweise sind die kartenseitigen Kontakthohlräume und die kartenseitigen Kontaktelemente jeweils gebogen ausgebildet, so dass sie eine im Wesentlichen rechtwinklige Kante aufweisen. Mit anderen Worten sind die kartenseitigen Kontakthohlräume und die kartenseitigen Kontaktelemente im Wesentlichen rechtwinklig ausgebildet. Eine im Wesentlichen rechtwinklige Kante bedeutet im Rahmen dieser Erfindung, dass Abschnitte der kartenseitigen Kontakthohlräume bzw. der kartenseitigen Kontaktelemente vor und nach der "Kante" im rechten Winkel zueinander stehen. Dabei ist die "Kante" selbst bzw. der Bereich, in dem sich die Richtung ändert, in der Regel nicht ideal rechtwinklig ausgebildet, sondern kann vielmehr eine Rundung aufweisen.

Im Rahmen der Erfindung soll insbesondere bedeuten, dass "im Wesentlichen" eine Eigenschaft erfüllt wird, wenn diese Eigenschaft zu zumindest 90% erfüllt wird, bevorzugt zu zumindest 95%, besonders bevorzugt zu zumindest 99%. Insbesondere kann diese Eigenschaft zu 100% erfüllt sein.

Weiter bevorzugt weisen die kartenseitigen Kontakthohlräume und die kartenseitigen Kontaktelemente eine im Wesentlichen rechtwinklige Kante auf und sind im montierten Zustand derart angeordnet, dass die im Wesentlichen rechtwinkligen Kanten zumindest eines Teils der kartenseitigen Kontakthohlräume und die im Wesentlichen rechtwinkligen Kanten zumindest eines Teils der kartenseitigen Kontaktelemente auf einer Geraden in einer von der ersten und zweiten Montagerichtung (bzw. von entsprechenden Richtungsvektoren) aufgespannten Ebene liegen, wobei die erste Montagerichtung im Wesentlichen senkrecht zur zweiten Montagerichtung ist und die Gerade sowohl zur ersten Montagerichtung als auch zur zweiten Montagerichtung, d.h. zu den entsprechenden Richtungsvektoren, einen Winkel von etwa 45° aufweist. Im Rahmen der vorliegenden Erfindung hat sich gezeigt, dass mit einer derartigen Ausführungsform den Anforderungen im Automotive Bereich, insbesondere hinsichtlich der notwendigen Signalqualität einerseits und einer möglichst hohen Platzeinsparung andererseits, besonders gut gerecht werden kann.

Weiter bevorzugt weist das kartenseitige Gehäuse ein erstes kartenseitiges Gehäuseelement mit einem ersten Endabschnitt und ein zweites kartenseitiges Gehäuseelement mit einem zu dem ersten kartenseitigen Gehäuseelement komplementären zweiten Endabschnitt auf. Der erste Endabschnitt weist insbesondere eine erste Öffnung auf, während der zweite Endabschnitt insbesondere eine zweite Öffnung aufweist. Der erste Endabschnitt bzw. die erste Öffnung und der zweite Endabschnitt bzw. die zweite Öffnung sind miteinander verbindbar. Im verbundenen Zustand bilden sie eine Verbindungsebene aus, welche sowohl zur ersten als auch zur zweiten Montagerichtung einen Winkel von etwa 45° aufweist. Dabei ist die erste Montagerichtung senkrecht zur zweiten Montagerichtung. Insbesondere ist das erste kartenseitige Gehäuseelement ausgelegt, um mit dem rechnerseitigen Gehäuseelement verbunden zu werden, während das zweite kartenseitige Gehäuseelement ausgelegt ist, um an die PCB-Karte angeschlossen zu werden. Insbesondere weist das zweite kartenseitige Gehäuseelement die Kühlrippen erster und zweiter Art auf. Dadurch dass das kartenseitige Gehäuse ein erstes und zweites kartenseitiges Gehäuseelement aufweist, wird vorteilhafterweise die Herstellung und die Montage des Verbindersystems vereinfacht.

Weiter bevorzugt weist das kartenseitige Gehäuse ein erstes kartenseitiges Gehäuseelement mit ersten kartenseitigen Kontakthohlräumen, die sich entlang der ersten Montagerichtung erstrecken, auf. Zusätzlich weist das kartenseitige Gehäuse ein zweites kartenseitiges Gehäuseelement mit zu den ersten kartenseitigen Kontakthohlräumen zugehörigen zweiten kartenseitigen Kontakthohlräumen, die sich entlang der zweiten Montagerichtung erstrecken, auf. Das erste und zweite kartenseitige Gehäuseelement sind im montierten Zustand derart miteinander verbunden, dass jeweils die ersten und die zugehörigen zweiten kartenseitigen Kontakthohlräume durch das kartenseitige Gehäuse durchgängige Kanäle ausbilden. Unter einem durchgängigen oder zusammenhängenden Kanal wird ein zusammenhängender oder durchgehender kartenseitiger Hohlraum verstanden. Insbesondere entsprechen die durch die ersten und zugehörigen zweiten kartenseitigen Kontakthohlräume ausgebildeten Kanäle den oben beschriebenen kartenseitigen Kontakthohlräumen. Auf diese Weise kann eine für den Automotive Bereich notwendige hohe Signalqualität durch eine optimale und durchgehende Schirmung der Kontaktelemente, d.h. der signalübertragenden Leiter, erreicht werden.

Weiter vorzugsweise weisen sämtliche erste kartenseitigen Kontakthohlräume, welche in ein und derselben, von der ersten und zweiten Montagerichtung aufgespannten, Ebene angeordnet sind, relativ zueinander eine unterschiedliche Länge auf. Ferner sind diese ersten kartenseitigen Kontakthohlräume stufenförmig angeordnet. Insbesondere sind Endabschnitte sämtlicher erster kartenseitiger Kontakthohlräume, welche in ein und derselben von der ersten und zweiten Montagerichtung aufgespannten Ebene angeordnet sind, entlang der ersten Montagerichtung relativ zueinander versetzt (d.h. stufenförmig) angeordnet. Entsprechend weisen sämtliche zweite kartenseitigen Kontakthohlräume, welche in ein und derselben, von der ersten und zweiten Montagerichtung aufgespannten, Ebene angeordnet sind, relativ zueinander eine unterschiedliche Länge auf und sind stufenförmig angeordnet. Insbesondere sind Endabschnitte sämtlicher zweiter kartenseitiger Kontakthohlräume, welche in ein und derselben, von der ersten und zweiten Montagerichtung aufgespannten, Ebene angeordnet sind, entlang der zweiten Montagerichtung relativ zueinander versetzt (d.h. stufenförmig) angeordnet. Im Rahmen der vorliegenden Erfindung hat sich gezeigt, dass mit einer derartigen Ausführungsform den Anforderungen im Automotive Bereich, insbesondere hinsichtlich der notwendigen Signalqualität einerseits und einer möglichst hohen Platzeinsparung andererseits besonders gut gerecht werden kann.

Weiter bevorzugt weisen die kartenseitigen Kontaktelemente jeweils wellenförmige Abschnitte auf, um bei einem Überlapp mit einem zugehörigen rechnerseitigen Kontaktelement das zugehörige rechnerseitige Kontaktelement an zumindest zwei unterschiedlichen Stellen elektrisch zu kontaktieren. Auch wenn in Folge der wellenartigen Abschnitte eine antennenartige Wirkung und somit Störsignale erwartet werden könnten, so hat sich im Rahmen der vorliegenden Erfindung überraschenderweise herausgestellt, dass dadurch die Qualität für die im Automotive Bereich übertragenen Signale bzw. Frequenzen nicht nennenswert beeinträchtigt werden. Vielmehr kann die Signalübertragung durch die wellenartige Form der kartenseitigen Kontaktelemente, insbesondere hinsichtlich Zuverlässigkeit, gesteigert werden, ohne dass die Kontaktstelle z.B. aufwendig verlötet werden muss.

Weiter bevorzugt weist das rechnerseitige Gehäuse zumindest ein Stabilisierungselement und das kartenseitige Gehäuse zumindest ein komplementäres Stabilisierungselement auf. Das zumindest eine Stabilisierungselement kann z.B. eine Aussparung oder eine Nut umfassen, während das komplementäre Stabilisierungselement einen Vorsprung, insbesondere einen Stabilisierungsstift bzw. einen Steckstift, welcher mit der Aussparung oder der Nut in Eingriff bringbar ist, umfassen kann. Auf diese Weise kann eine erhöhte Stabilität des Verbindersystems erreicht werden, was vor allem im Automotive Bereich wichtig ist, um einen Signalausfall zu vermeiden. Ferner dienen die Stabilisatoren zusätzlich als Steckhilfe.

Weiter bevorzugt weist das kartenseitige Gehäuse zumindest ein Federelement auf, welches das kartenseitige Gehäuse elektrisch kontaktiert und welches ausgelegt ist, um im montierten Zustand auch das rechnerseitige Gehäuse elektrisch zu kontaktieren. Mit Hilfe des Federelements wird das kartenseitige Gehäuse mit dem rechnerseitigen Gehäuse elektrisch verbunden, was die Schirmwirkung und damit die Signalqualität des Verbindersystems erhöht.

Weiter bevorzugt weist das kartenseitige Gehäuse, und insbesondere das zweite kartenseitige Gehäuseelement, weitere Lötstellen auf, um auf die PCB-Karte gelötet zu werden. Auch dies bewirkt eine verbesserte Schirmung und damit eine verbesserte Signalqualität des Verbindersystems.

Vorzugsweise umfasst die Vielzahl von rechnerseitigen Kontakthohlräumen des rechnerseitigen Gehäuses einen rechnerseitigen Power-Kontakthohlraum, einen rechnerseitigen Single-End-Kontakthohlraum und eine Vielzahl von rechnerseitigen Differential-Pair-Kontakthohlräumen. Ferner umfasst die Vielzahl von rechnerseitigen Isolierkörpern einen rechnerseitigen Power-Isolierkörper, welcher im montierten Zustand in dem rechnerseitigen Power-Kontakthohlraum angeordnet ist, einen rechnerseitigen Single-End-Isolierkörper, welcher im montierten Zustand in dem rechnerseitigen Single-End-Kontakthohlraum angeordnet ist, und eine Vielzahl von rechnerseitigen Differential-Pair-Isolierkörpern, welche im montierten Zustand jeweils in einem zugehörigen rechnerseitigen Differential-Pair-Kontakthohlraum der Vielzahl von rechnerseitigen Differential-Pair-Kontakthohlräumen angeordnet ist. Ferner umfasst die Vielzahl von rechnerseitigen Kontaktelementen eine Vielzahl von rechnerseitigen Power-Kontaktelementen, welche im montierten Zustand zumindest bereichsweise in Hohlräumen des rechnerseitigen Power-Isolierkörpers angeordnet sind, eine Vielzahl von rechnerseitigen Single-End-Kontaktelementen, welche im montierten Zustand zumindest bereichsweise in Hohlräumen des rechnerseitigen Single-End-Isolierkörpers angeordnet sind, und eine Vielzahl von rechnerseitigen Differential-Pair-Kontaktelementen, welche im montierten Zustand jeweils zumindest bereichsweise in einem Hohlraum eines zugehörigen rechnerseitigen Differential-Pair-Isolierkörpers der Vielzahl von rechnerseitigen Differential-Pair-Isolierkörpern angeordnet sind.

Entsprechend umfasst die Vielzahl von kartenseitigen Kontakthohlräumen des kartenseitigen Gehäuses vorzugsweise einen kartenseitigen Power-Kontakthohlraum, einen kartenseitigen Single-End-Kontakthohlraum und eine Vielzahl von kartenseitigen Differential-Pair-Kontakthohlräumen. Ferner umfasst die Vielzahl von kartenseitigen Isolierkörpern einen kartenseitigen Power-Isolierkörper, welcher im montierten Zustand in dem kartenseitigen Power-Kontakthohlraum angeordnet ist, einen kartenseitigen Single-End-Isolierkörper, welcher im montierten Zustand in dem kartenseitigen Single-End-Kontakthohlraum angeordnet ist, und eine Vielzahl von kartenseitigen Differential-Pair-Isolierkörpern, welche im montierten Zustand jeweils in einem zugehörigen kartenseitigen Differential-Pair-Kontakthohlraum der Vielzahl von kartenseitigen Differential-Pair-Kontakthohlräumen angeordnet ist. Ferner umfasst die Vielzahl von kartenseitigen Kontaktelementen eine Vielzahl von kartenseitigen Power-Kontaktelementen, welche im montierten Zustand zumindest bereichsweise in Hohlräumen des kartenseitigen Power-Isolierkörpers angeordnet sind, eine Vielzahl von kartenseitigen Single-End-Kontaktelementen, welche im montierten Zustand zumindest bereichsweise in Hohlräumen des kartenseitigen Single-End-Isolierkörpers angeordnet sind, und eine Vielzahl von kartenseitigen Differential-Pair-Kontaktelementen, welche im montierten Zustand jeweils zumindest bereichsweise in einem Hohlraum eines zugehörigen kartenseitigen Differential-Pair-Isolierkörpers der Vielzahl von kartenseitigen Differential-Pair-Isolierkörpern angeordnet sind.

Beispielsweise können 48 rechnerseitige und 48 kartenseitige Differential-Pair-Kontakthohlräume vorgesehen sein. Entsprechend können 48 rechnerseitige und 48 kartenseitige Differential-Pair-Isolierkörper sowie 48 rechnerseitige und 48 kartenseitige Differential-Pair-Kontaktelementpaare vorgesehen sein, wobei jedes Differential-Pair-Kontaktelementpaar zwei Kontaktelemente umfasst. Beispielsweise können 8 rechnerseitige und 8 kartenseitige Powerkontakte vorgesehen sein, wobei jeweils vier der kartenseitigen und rechnerseitigen Powerkontakte zwei Powerkontaktpins umfassen und wobei jeweils die restlichen vier kartenseitigen und rechnerseitigen Powerkontakte drei Powerkontaktpins umfassen. Beispielsweise können 56 rechnerseitige und 56 kartenseitige Single-End-Kontaktelemente vorgesehen sein.

Vorteilhafterweise sind sämtliche Power-Kontakthohlräume bzw. Power-Isolierkörper bzw. Power-Kontaktelemente auf einer Seite, d.h. einem Endabschnitt des rechnerseitigen bzw. kartenseitigen Verbinderelements bzw. Gehäuses angeordnet. Somit können Störeinflüsse bei der Signalübertragung reduziert oder vermieden werden. Weiterhin entsteht dadurch der Vorteil, dass bei dem mit dem Verbindersystem zu verbindenden Zentralrechner und bei der mit dem Verbindersystem zu verbindenden PCB-Karte die dort verlaufenden breiten Powerleitungen und somit auch sämtliche Verbraucher auf einer Seite des Zentralrechners bzw. der PCB-Karte angeordnet werden können. Würden hingegen die Powerleitungen an verschiedenen Stellen, d.h. nicht nur auf einer Seite, des Verbindersystems angeordnet sein, so müßten die Powerleitungen im Zentralrechner und/oder auf der PCB-Karte gekreuzt verlaufen, was insgesamt zu einem höheren Platzbedarf führen würde.

Für den oben genannten weiteren Aspekt und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen unabhängigen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1: zeigt in einer perspektivischen Explosionsansicht eine schematische Skizze eines Verbindersystems gemäß einer bevorzugten Ausführungsform der vorliegenden Erfindung;
- Figur 2A: zeigt in einer ersten perspektivischen Ansicht (Vorderansicht) eine schematische Skizze des rechnerseitigen Gehäuses des Verbindersystems aus Figur 1;
- Figur 2B: zeigt in einer zweiten perspektivischen Ansicht (Rückansicht) eine schematische Skizze des rechnerseitigen Gehäuses des Verbindersystems aus Figur 1;
- Figur 3: zeigt in der perspektivischen Ansicht aus Figur 2A (Vorderansicht) eine schematische Skizze des rechnerseitigen Verbinderelements des Verbindersystems aus Figur 1 ohne das rechnerseitige Gehäuse.
- Figur 4: zeigt in einer perspektivischen Ansicht eine schematische Skizze des kartenseitigen Verbinderelements von Figur 1;
- Figur 5a: zeigt in einer Draufsicht eine schematische Skizze des kartenseitigen Verbinderelements von Figur 1;
- Figur 5b: zeigt in einer Untersicht eine schematische Skizze des kartenseitigen Verbinderelements von Figur 1;
- Figur 6a: zeigt in einer perspektivischen Ansicht von unten eine schematische Skizze des kartenseitigen Verbinderelements von Figur 1;
- Figur 6b: zeigt in einer Draufsicht eine schematische Skizze eines vergrößerten Ausschnitts des kartenseitigen Verbinderelements;
- Figur 7: zeigt in einer perspektivischen Explosionsansicht eine schematische Skizze des kartenseitigen Verbinderelements gemäß einer bevorzugten Ausführungsform;
- Figur 8a: zeigt in einer perspektivischen Ansicht eine schematische Skizze eines zweiten kartenseitigen Gehäuseelements des kartenseitigen Verbinderelements von Figur 1;
- Figur 8b: zeigt eine schematische Skizze des zweiten kartenseitigen Gehäuseelements von Figur 8a in einer weiteren perspektivischen Ansicht.

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen. Die Zusatzbezeichnung "rechnerseitig", wie sie in der vorliegenden Beschreibung für verschiedene Elemente verwendet wird, soll andeuten, dass diese Elemente zu dem rechnerseitigen Verbinderelement, d.h. einem Verbinderelement, welches unmittelbar mit dem Zentralrechner verbunden werden kann, gehören. Entsprechend deutet die Zusatzbezeichnung "kartenseitig" bei verschiedenen Elementen an, dass diese Elemente zu dem kartenseitigen Verbinderelement, d.h. einem Verbinderelement, welches unmittelbar mit einer PCB-Karte verbunden werden kann, gehören.

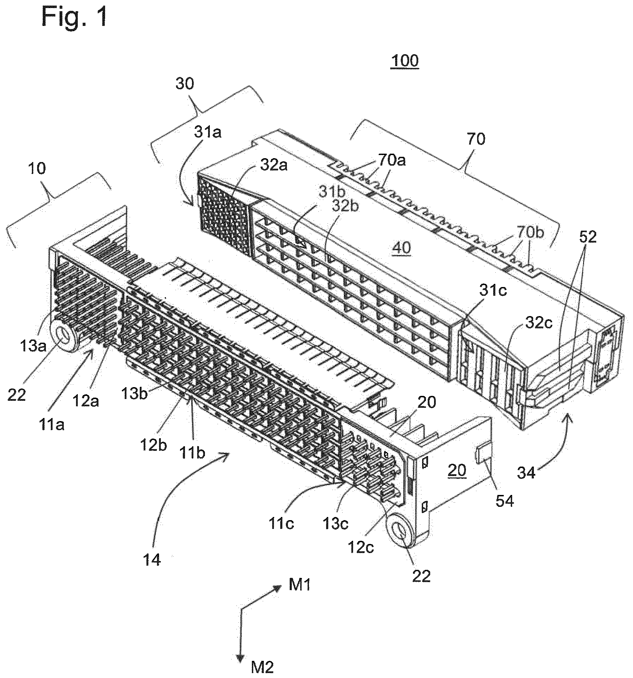

Die Figur 1 zeigt in einer perspektivischen Explosionsansicht eine schematische Skizze eines erfindungsgemäßen Verbindersystems 100. In dieser Explosionsansicht ist ein rechnerseitiges Verbinderelement 10 und ein kartenseitiges Verbinderelement 30 des Verbindersystems 100 separat, d.h. in einem nicht zusammengesteckten bzw. montierten Zustand gezeigt. Im vollständig montierten Zustand sind das rechnerseitige Verbinderelement 10 und das kartenseitige Verbinderelement 30 miteinander verbunden, d.h. entlang einer mit einem Pfeil gekennzeichneten ersten Montagerichtung M1 zusammengesteckt.

Das rechnerseitige Verbinderelement 10 ist ausgelegt, um mit einer rechnerseitigen Steckseite 14 voran an einen Zentralrechner eines Kraftfahrzeugs (nicht gezeigt) angeschlossen bzw. angesteckt zu werden. Im gezeigten Ausführungsbeispiel ist die Steckseite 14 im montierten Zustand diejenige Seite des rechnerseitigen Verbinderelements 10, welche dem kartenseitigen Verbinderelement 30 abgewandt ist. Eine Normale auf die rechnerseitige: Steckseite 14 ist etwa entgegengesetzt parallel zur ersten Montagerichtung M1 angeordnet.

Das rechnerseitige Verbinderelement 10 weist eine Mehrzahl von Kontaktelementen 13a, 13b und 13c auf, die mit komplementären Kontaktelementen des Zentralrechners verbunden werden können. Im Ausführungsbeispiel der Figur 1 weist das Verbindersystem 100 bzw. das rechnerseitige Verbinderelement 10 (und analog dazu das kartenseitige Verbinderelement 30) drei unterschiedliche Kontaktbereiche auf, nämlich einen Single-End-Kontaktbereich mit einer Mehrzahl von Single-End-Kontaktelementen 13a, einen Differential-Pair-Kontaktbereich mit einer Mehrzahl von Differential-Pair-Kontaktelementen 13b und einen Power-Kontaktbereich mit einer Mehrzahl von Power-Kontaktelementen 13c. Während die Single-End-Kontaktelemente 13a Signale bzw. Informationen jeweils nur über einen einzelnen elektrischen Leiter übertragen, so werden bei den Differential-Pair-Kontaktelementen 13b jeweils zwei elektrische Leiter verwendet, um ein Differenzsignal dieser beiden Leiter zu übertragen. Einige der Power-Kontaktelemente 13c sind im gezeigten Ausführungsbeispiel ähnlich wie die Differential-Pair-Kontaktelemente 13b jeweils paarweise ausgeführt, während andere als 3er-Kontakt ausgeführt sind. Die Power-Kontaktelemente 13c dienen zur Leistungsübertragung.

Das rechnerseitige Verbinderelement 10 weist ein rechnerseitiges Gehäuse 20 mit einer Mehrzahl von rechnerseitigen Kontakthohlräumen 11a, 11b, und 11c auf, nämlich einem rechnerseitigen Single-Pair-Kontakthohlraum 11a, einer Mehrzahl (hier genau 48) rechnerseitige Differential-Pair-Kontakthohlräume 11b und einem rechnerseitigen Power-Kontakthohlraum 11c. Sämtliche Kontakthohlräume 11a-11c sind durch das rechnerseitige Gehäuse 20 hindurch verlaufend ausgebildet und durchdringen somit das rechnerseitige Gehäuse 20 vollständig. Die Kontakthohlräume 11a-11c weisen (in erster Montagerichtung M1, siehe unten) einen etwa konstanten Querschnitt auf, welcher z.B. etwa rechteckig ausgebildet ist. Ferner weist das rechnerseitige Verbinderelement 10 eine Mehrzahl von rechnerseitigen Isolierkörpern 12a, 12b und 12c auf, welche jeweils zumindest einen Isolierraum ausbilden und umschließen, der durch das rechnerseitige Gehäuse 20 hindurch verlaufend ausgebildet ist.

Die Isolierkörper 12a, 12b und 12c sind innerhalb der rechnerseitigen Kontakthohlräume 11a-11c angeordnet. Im gezeigten Ausführungsbeispiel weist das rechnerseitige Verbinderelement 10 einen rechnerseitigen Single-Pair-Isolierkörper 12a auf, eine Mehrzahl (hier genau 48) rechnerseitige Differential-Pair-Isolierkörper 12b und einen rechnerseitigen Power-Isolierkörper 12c.

Die rechnerseitigen Kontaktelemente 13a-13c sind im montierten Zustand zumindest bereichsweise innerhalb von rechnerseitigen Isolierhohlräumen der jeweils zugehörigen rechnerseitigen Isolierkörper 12a-12c angeordnet. So sind die Single-End-Kontaktelemente 13a im Single-End-Kontakthohlraum 11a und innerhalb von Isolierhohlräumen des Single-End-Isolierkörpers 12a angeordnet. Die Differential-Pair-Kontaktelemente 13b sind jeweils in zugehörigen Differential-Pair-Kontakthohlräumen 11b und innerhalb von zugehörigen Isolierhohlräumen der Differential-Pair-Isolierkörper 12b angeordnet. Die Power-Kontaktelemente 13c sind in dem Power-Kontakthohlraum 11c und jeweils innerhalb von zugehörigen Isolierhohlräumen des Power-Isolierkörpers 12c angeordnet.

Das rechnerseitige Gehäuse 20 weist zumindest eine Schrauböffnung 22 auf, im gezeigten Ausführungsbeispiel genau zwei Schrauböffnungen 22. Jede Schrauböffnung 22 ist einstückig mit dem Gehäuse 20 als Zinkdruckgussbauteil ausgebildet. Die Schrauböffnungen 22 sind an einem Rand der rechnerseitigen Steckseite 14 des rechnerseitigen Gehäuses 20 ausgebildet. Dabei weist jede Schrauböffnung 22 eine kreisförmige Umrandung auf, welche einen Hohlzylinderabschnitt umgibt, in welchen eine Schraube eingeschraubt werden kann. Die Zylinderachse des Hohlzylinderabschnitts ist etwa parallel zur ersten Montagerichtung M1 und/oder zu den kartenseitigen Kontaktelementen 13a-13c angeordnet. Somit kann das rechnerseitige Gehäuse 20 mittels in die Schrauböffnungen 22 geschraubte Schrauben an dem (nicht gezeigten) Zentralrechner befestigt werden. Dabei werden die Schrauben in etwa parallel zu den rechnerseitigen Kontaktelementen 13a-13c durch die Schrauböffnungen geschraubt. Dadurch wird die Befestigung des rechnerseitigen Verbinderelements 10 am Zentralrechner verstärkt und/oder gesichert.

Das kartenseitige Verbinderelement 30 ist ausgelegt, um mit einer PCB-Karte entlang einer zweiten Montagerichtung M2 verbunden zu werden. Dazu weist das kartenseitige Verbinderelement 30 auf seiner Unterseite, der kartenseitigen Steckseite 34, rechnerseitigen Kontaktelementen 13a-13c entsprechende kartenseitige Kontaktelemente (in Figur 1 nicht gezeigt) auf. Dabei sind die kartenseitigen Kontaktelemente etwa rechtwinklig ausgebildet mit einem ersten Abschnitt, der sich etwa parallel zur ersten Montagerichtung M1 erstreckt, und einem zweiten Abschnitt, der sich etwa parallel zur zweiten Montagerichtung M2 erstreckt. Der zweite Abschnitt der kartenseitigen Kontaktelemente kann hierbei aus der kartenseitigen Steckseite 34 herausragen zum (elektrischen und/oder physikalischen) kontaktieren der PCB-Karte.

Wie in der Figur 1 gezeigt, ist die zweite Montagerichtung M2 im Wesentlichen senkrecht zur ersten Montagerichtung M1 ausgerichtet. Das kartenseitige Verbinderelement 30 ist dazu ausgebildet und vorgesehen, mit seiner kartenseitigen Steckseite 34 voran in Richtung der zweiten Montagerichtung M2 an der (nicht gezeigten) PCB-Karte befestigt, z.B. verlötet, zu werden. Die kartenseitige Steckseite 34 ist im montierten Zustand in einer Ebene angeordnet, die etwa senkrecht zu der Ebene angeordnet ist, in der die rechnerseitige Steckseite 14 angeordnet ist.

Das kartenseitige Verbinderelement 30 weist ein kartenseitiges Gehäuse 40 mit einer Mehrzahl von kartenseitigen Kontakthohlräumen 31a-31c auf. Dabei kann das kartenseitige Gehäuse 40 einstückig ausgebildet sein oder zumindest zwei kartenseitige Gehäuseelemente aufweisen, welche miteinander verbunden bzw. zusammengesteckt werden können.

Das kartenseitige Gehäuse 40 weist eine Mehrzahl von kartenseitigen Isolierkörpern 32a-32c auf, welche im montierten Zustand innerhalb der kartenseitigen Kontakthohlräume 31a-31c angeordnet sind. Die kartenseitigen Isolierkörper 32a-32c wiederum weisen kartenseitige Isolierhohlräume auf, die ausgelegt sind, um im montierten Zustand zugehörige rechnerseitige Kontaktelemente 13a-13c zumindest bereichsweise aufzunehmen. Sowohl die kartenseitigen Kontakthohlräume 31a-31c, die kartenseitigen Isolierkörpern 32a-32c, als auch die kartenseitigen Kontaktelemente sind winklig ausgebildet. Die kartenseitigen Kontakthohlräume 31a-31c usw. weisen dabei einen ersten Abschnitt auf, welcher etwa parallel zur ersten Montagerichtung M1 ausgebildet ist, und einen zweiten Abschnitt, welcher etwa parallel zur zweiten Montagerichtung M2 ausgebildet ist.

Im gezeigten Ausführungsbeispiel weist das kartenseitige Verbinderelement 30 einen kartenseitigen Single-Pair-Isolierkörper 32a, eine Mehrzahl (hier genau 48) kartenseitige Differential-Pair-Isolierkörper 32b und einen kartenseitigen Power-Isolierkörper 32c auf. Die kartenseitigen Kontaktelemente (nicht in Figur 1 gezeigt) sind im montierten Zustand zumindest bereichsweise innerhalb von kartenseitigen Isolierhohlräumen der jeweils zugehörigen kartenseitigen Isolierkörper 32a-32c angeordnet. So sind Single-End-Kontaktelemente im Single-End-Kontakthohlraum 31a und innerhalb von Isolierhohlräumen des Single-End-Isolierkörpers 32a angeordnet. Differential-Pair-Kontaktelemente bzw. Differential-Pair-Kontaktelementpaare sind jeweils in zugehörigen Differential-Pair-Kontakthohlräumen 31b und innerhalb von zugehörigen Isolierhohlräumen der Differential-Pair-Isolierkörper 32b angeordnet. Power-Kontaktelemente sind in dem Power-Kontakthohlraum 31c und innerhalb von zugehörigen Isolierhohlräumen des Power-Isolierkörpers 32c angeordnet.

Im montierten Zustand, in dem das rechnerseitige Verbinderelement 10 mit dem kartenseitigen Verbinderelement 30 verbunden und/oder zusammengesteckt ist, kontaktieren sich die rechnerseitigen Kontaktelemente 13a-13c und die kartenseitigen Kontaktelemente in den kartenseitigen Kontakthohlräumen 31a-31c und in den Isolierhohlräumen der kartenseitigen Isolierkörper 32a-32c.

Das kartenseitige Gehäuse 40 weist eine Mehrzahl von Kühlrippen 70 auf, wobei einige dieser Kühlrippen 70, nämlich die sogenannten Kühlrippen zweiter Art 70b, vorgesehen und ausgelegt sind, um das kartenseitige Gehäuse 40 mit der PCB-Karte mechanisch und wärmeleitfähig zu verbinden. Die Kühlrippen 70 umfassen also mehrere Kühlrippen erster Art 70a und mehrere Kühlrippen zweiter Art 70b. Wie in der Figur 1 zu sehen ist, weisen die Kühlrippen erster Art 70a, welche auch als Standardkühlrippen bezeichnet werden, eine andere Form bzw. einen anderen Querschnitt als die Kühlrippen zweiter Art 70b, welche auch als PCB-Verbindungskühlrippen bezeichnet werden, auf. Die PCB-Verbindungskühlrippen 70b haben im Vergleich zu den Standardkühlrippen 70a im Allgemeinen jeweils größere Abmessungen und insbesondere eine größere Länge. In der hier gezeigten Ausführungsform haben die Verbindungskühlrippen 70b im Vergleich zu den Standardkühlrippen 70a auch eine größere Dicke, einen größeren Umfang und/oder einen größeren Durchmesser. Wie bereits aus der Figur 1 ersichtlich, erstrecken sich die PCB-Verbindungskühlrippen 70b weiter vom Gehäuse 40 entlang der ersten Montagerichtung M1 weg als die Standardkühlrippen 70a.

Die PCB-Verbindungskühlrippen 70b sind ausgelegt und angeordnet, um das kartenseitige Gehäuse 40, insbesondere über einen Endabschnitt der jeweiligen PCB-Verbindungskühlrippen 70b, entlang der Montagerichtung M2 mit der PCB-Karte mechanisch und wärmeleitfähig zu verbinden. Das kartenseitige Verbinderelement 30 kann somit mit Hilfe der PCB-Verbindungskühlrippen 70b an der PCB-Karte auch mechanisch fixiert bzw. befestigt werden.

In dem Ausführungsbeispiel der Figur 1 weist das kartenseitige Gehäuse 40 insgesamt 12 PCB-Verbindungskühlrippen 70b auf. Zwischen zwei benachbarten PCB-Verbindungskühlrippen 70b ist jeweils eine Standardkühlrippe 70a angeordnet.

Das rechnerseitige Gehäuse 20 kann ferner eine Mehrzahl von Stabilisierungselementen aufweisen, während das kartenseitige Gehäuse 40 eine entsprechende Anzahl von komplementären Stabilisierungselementen aufweisen kann. Beim Zusammenstecken des rechnerseitigen Verbinderelements 10 und des kartenseitigen Verbinderelements 30 greifen die Stabilisierungselemente ineinander ein und stabilisieren die Steckverbindung im montierten Zustand. Zusätzlich können die Stabilisierungselemente auch als Steckhilfe dienen.

Das kartenseitige Gehäuse 40 weist zudem zumindest ein Führungselement 52, z.B. einen Vorsprung, auf, welcher beim Zusammenstecken des rechnerseitigen Verbinderelements 10 und des kartenseitigen Verbinderelements 30 in ein komplementäres Führungselement 54 des rechnerseitigen Gehäuses 10 eingreift. Dabei kann eines der Führungselemente 52 länglich ausgebildet sein, etwa parallel zur ersten Montagerichtung M1 ausgerichtet sein und/oder sich in Richtung zum zugeordneten Verbinderelement 10 bzw. 30 hin verjüngend ausgebildet sein. Dies erleichtert das Ausrichten des rechnerseitigen und kartenseitigen Verbinderelements 10 und 30 beim Zusammenstecken und somit die Montage des Verbindersystems 100.

Das rechnerseitige Gehäuse 20 und das kartenseitige Gehäuse 40 sind vorzugsweise jeweils aus Zinkdruckguss ausgebildet und gefertigt, in welchem die Kontakthohlräume 12a-12c bzw. 32a-32c vorgesehen sind. Dadurch kann bewirkt werden, dass die rechnerseitigen Kontaktelemente 13a-13c und die kartenseitigen Kontaktelemente nicht nur mechanisch geschützt sind, sondern auch elektrisch geschirmt sind, um elektromagnetische Störeinflüsse zu reduzieren und/oder zu vermeiden. Die Signalqualität kann dadurch signifikant erhöht werden. Ferner eignet sich Zinkdruckguss auch sehr gut als Material für die Kühlrippen 70.

Ferner kann das kartenseitige Gehäuse 40 ein Federelement aufweisen, welches das kartenseitige Gehäuse 40 elektrisch kontaktiert und welches ausgelegt ist, um im montierten Zustand auch das rechnerseitige Gehäuse 20 elektrisch zu kontaktieren. Somit besteht ein elektrischer Kurzschluss zwischen den beiden Gehäusen 20 und 40, was die Schirmung der Kontaktelemente und damit die Signalqualität weiter verbessert.

Das rechnerseitige Verbinderelement 10 und das kartenseitige Verbinderelement 30 können z.B. eine Länge (etwa senkrecht zu den beiden Montagerichtungen M1 und M2) von etwa 85 mm, eine Tiefe (etwa parallel zur ersten Montagerichtung M1) von etwa 15 mm und eine Höhe (etwa parallel zur zweiten Montagerichtung M2) von etwa 12 mm aufweisen. Diese Abmessungen sind lediglich beispielhaft für den Automotive-Bereich und können je nach Anwendung auch andere für den Automotive Bereich geeignete Dimensionen einnehmen.

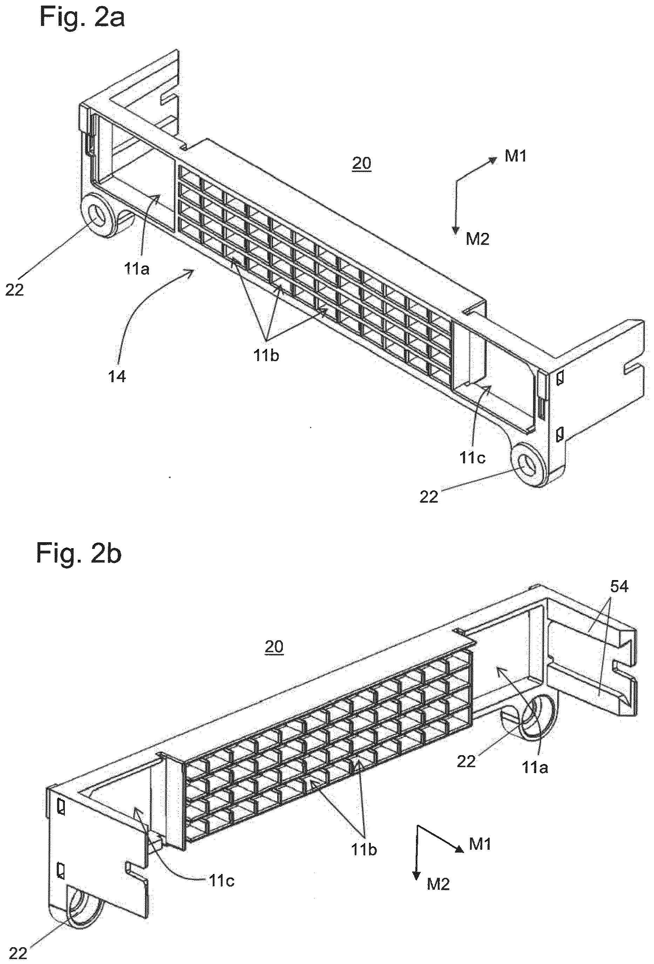

Die **Figur 2A** zeigt in einer ersten perspektivischen Ansicht (schräge Vorderansicht) eine schematische Skizze des rechnerseitigen Gehäuses 20 des in Figur 1 gezeigten Verbindersystems 100, während die **Figur 2B** das rechnerseitige Gehäuse 20 in einer zweiten perspektivischen Ansicht (schräge Rückansicht) zeigt. In den Figuren 2A und 2B sind nochmals die Kontakthohlräume 11a-11c gezeigt, welche das rechnerseitige Gehäuse 20 vollständig durchdringen und einen etwa rechteckigen Querschnitt aufweisen.

Wie in den Figuren 2A und 2B gezeigt, weist insbesondere jeder einzelne der Kontakthohlräume 11b einen etwa rechteckigen Querschnitt auf zum drehfesten Aufnehmen der Differential-Pair-Isolierkörper 12b. Beim Zusammenstecken des rechnerseitigen Verbinderelements 10 und des kartenseitigen Verbinderelements 30, d.h. im montierten Zustand, werden von den rechnerseitigen Kontakthohlräume 11a-11c und den kartenseitigen Kontakthohlräume 31a-31c zusammen durchgängige Kanäle und/oder Hohlräume für die Kontaktelemente ausgebildet.

Im montierten Zustand können die beiden Gehäuse 20 und 40 aneinander gekoppelt und/oder elektrisch kontaktiert sein, was die Schirmung verbessert.

Eine erste Schrauböffnung 22 ist benachbart zum rechnerseitigen Single-End Kontakthohlraum 11a am rechnerseitigen Gehäuse 20 ausgebildet. Eine zweite Schrauböffnung 22 ist benachbart zum rechnerseitigen Power Kontakthohlraum 11c am rechnerseitigen Gehäuse 20 ausgebildet.

Jede Schrauböffnung 22 ist als (z.B. flächige) Vergrößerung der rechnerseitigen Steckseite 14 ausgebildet und kann schlaufenartig vom rechnerseitigen Gehäuse 20 abstehen. Im gezeigten Ausführungsbeispiel stehen die etwa kreisförmigen Umrandungen der Schrauböffnungen 22 in etwa in der zweiten Montagerichtung M2 vom rechnerseitigen Gehäuse 20 ab.

Auch das in Figur 1 gezeigte kartenseitige Gehäuse 40 kann Schrauböffnungen aufweisen (nicht in den Figuren gezeigt), welche als Zinkdruckguss-Elemente ausgebildet sein können und zum Verstärken der Verbindung des kartenseitigen Verbinderelements 30 mit der PCB-Karte dienen. Schrauböffnungen am kartenseitigen Gehäuse 40 können z.B. als Vergrößerung der kartenseitigen Steckseite 34 ausgebildet sein (vgl. Fig. 1).

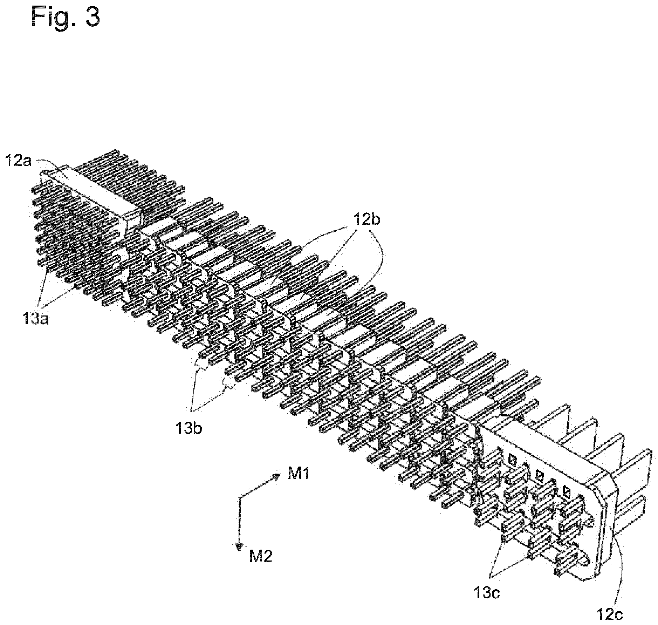

Die **Figur 3** zeigt eine schematische Skizze des rechnerseitigen Verbinderelements 10 aus Figur 1. Im Vergleich zur Figur 1 wurde in der Figur 3 z.B. das rechnerseitige Gehäuse 20 ausgeblendet, so dass die rechnerseitigen Isolierkörper 12a-12c und die rechnerseitigen Kontaktelemente 13a-13c besser gezeigt sind. Insbesondere ist in Figur 3 gezeigt, dass die hohlförmigen Isolierkörper 12a-12c die Kontaktelemente 13a-13c zumindest bereichsweise umgeben. Mit anderen Worten sind die Kontaktelemente 13a-13c zumindest bereichsweise innerhalb von Hohlräumen der Isolierkörper 12a-12c angeordnet.

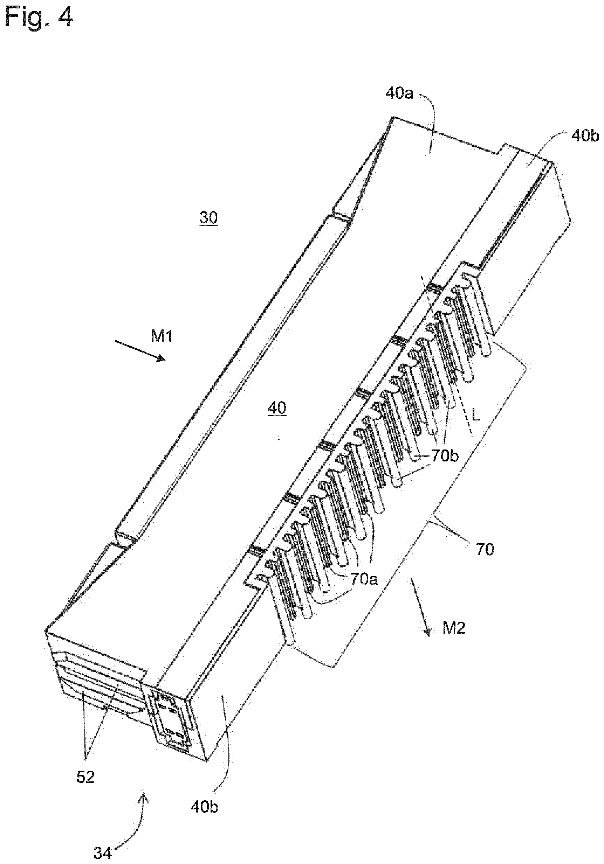

Die **Figur 4** zeigt in einer weiteren perspektivischen Ansicht (schräge Rückansicht) das kartenseitige Verbinderelement 30 der Figur 1. Das kartenseitige Gehäuse 40 ist zweiteilig ausgebildet und weist ein erstes kartenseitiges Gehäuseelement 40a und ein zweites kartenseitges Gehäuseelement 40b auf. Die Kühlrippen 70 sind an dem zweiten kartenseitgen Gehäuseelement 40b angeordnet bzw. in diesem ausgebildet. Sowohl die Standardkühlrippen 70a als auch die PCB-Verbindungskühlrippen 70b können säulenförmig oder im Wesentlichen zylindrisch ausgebildet sein. Alternativ können die Standardkühlrippen 70a und/oder die PCB-Verbindungskühlrippen 70b auch einen rechteckigen Querschnitt aufweisen. Wie in der Figur 4 ersichtlich, können die Standardkühlrippen 70a einen rechteckförmigen Querschnitt und die PCB-Verbindungskühlrippen 70b einen kreisförmigen Querschnitt aufweisen. Sowohl die Standardkühlrippen 70a als auch die PCB-Verbindungskühlrippen 70b erstrecken sich mit einer Längsachse L vom oberen Rand des Gehäuses 40 bzw. zweiten Gehäuseelements 40b entlang der zweiten Montagerichtung M2 zu einem unteren Rand des zweiten Gehäuseelements 40b, d.h. in Richtung des kartenseitigen Steckendes 34.

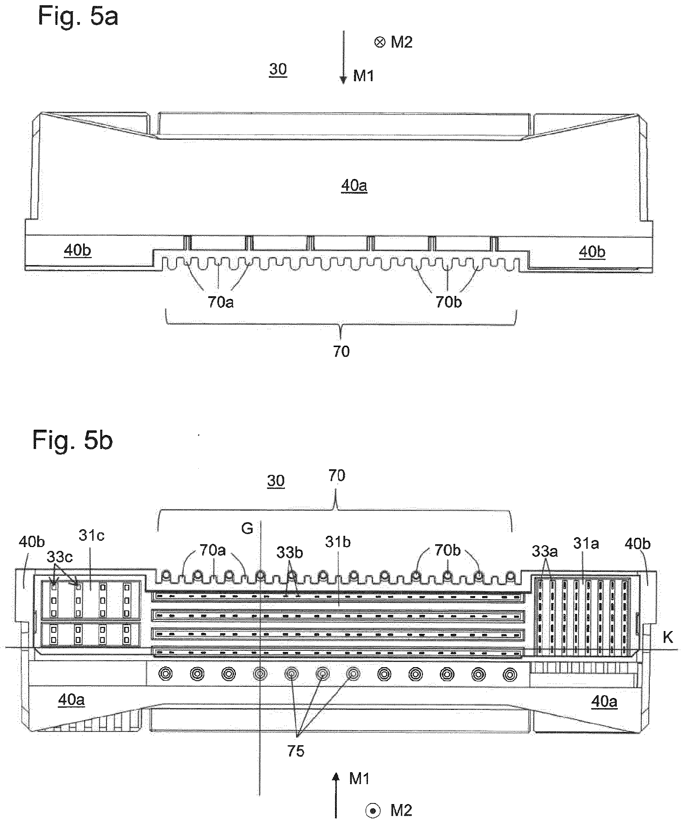

In der **Figur 5a** ist das kartenseitige Verbinderelement 30 der Figur 1 in einer Draufsicht dargestellt, d.h. die erste Montagerichtung M1 zeigt in dieser Darstellung nach unten, während die zweite Montagerichtung M2 in die Zeichenebene zeigt. Insbesondere ist in dieser Ansicht die unterschiedliche Form bzw. der unterschiedliche Querschnitt der Standardkühlrippen 70a und der PCB-Verbindungskühlrippen 70b gut erkennbar.

In der **Figur 5b** ist das kartenseitige Verbinderelement 30 der Figur 1 in einer Untersicht dargestellt, d.h. die erste Montagerichtung M1 zeigt in dieser Darstellung nach oben, während die zweite Montagerichtung M2 aus der Zeichenebene heraus zeigt. Die in der Figur 5b gezeigte Seite des Verbinderelements 30 ist somit die kartenseitige Steckseite 34, welche mit der PCB-Karte verbunden werden kann bzw. im montierten Zustand mit dieser verbunden ist. In der Darstellung von Figur 5b sind auch die kartenseitigen Single-Pair Kontaktelemente 33a und die kartenseitigen Differential-Pair Kontaktelemente bzw. Differential-Pair Kontaktelementpaare 33b gezeigt. Die kartenseitigen Power-Kontaktelemente 33c sind in der Figur 5b durch Pfeile angedeutet. Wie aus der Figur 5b ersichtlich, entspricht die Anzahl an PCB-Verbindungskühlrippen 70b der Anzahl N von in einer Reihe angeordneten kartenseitigen Differential-Pair Kontaktelementpaaren 33b. Dabei erstreckt sich die Reihe, in der N kartenseitige Differential-Pair Kontaktelementpaare 33b angeordnet sind, entlang einer Längsachse K des kartenseitigen Verbinderelements, wobei diese Längsachse K senkrecht zur ersten Montagerichtung M1 und senkrecht zur zweiten Montagerichtung M2 ausgerichtet ist. Ferner umfasst das kartenseitige Verbinderelement 30 N Spalten mit jeweils M Differential-Pair Kontaktelementpaaren 33b, wobei sich die Spalten jeweils entlang der ersten Montagerichtung M1 erstrecken. Im Ausführungsbeispiel der Figur 5b beträgt die Anzahl an Spalten N = 12 und die Anzahl an Reihen M = 4, so dass das kartenseitige Verbinderelement 30 insgesamt NxM = 48 Differential-Pair Kontaktelementpaare 33b aufweist.

Wie aus Figur 5b hervorgeht, ist jede PCB-Verbindungskühlrippe 70b auf Höhe eines Differential-Pair Kontaktelementpaares 33b bzw. auf Höhe einer der N Spalten von Differential-Pair Kontaktelementpaaren 33b angeordnet. Mit anderen Worten sind die Kühlrippen 70 derart angeordnet, dass jede PCB-Verbindungskühlrippe 70b eine Gerade G schneidet, welche sich zwischen den Kontaktelementen eines Differential-Pair Kontaktelementpaares 33b des kartenseitigen Verbinderelements 30 befindet und entlang der ersten Montagerichtung M1 ausgerichtet ist. Eine dieser Geraden G ist in der Figur 5b eingezeichnet. Die Gerade(n) G steht/stehen senkrecht zur Längsachse K des kartenseitigen Verbinderelements 30 und auch senkrecht zur zweiten Montagerichtung M2.

Weiterhin weist das kartenseitige Gehäuse 40 bzw. das erste kartenseitige Gehäuseelement 40a, also das Gehäuselement ohne Kühlrippen, PCB-Befestigungselemente 75 auf, die eine ähnliche oder identische Form wie die PCB-Verbindungskühlrippen 70b aufweisen. Insbesondere erstrecken sich die PCB-Befestigungselemente 75 gleich weit vom kartenseitigen Gehäuse 40 weg wie die PCB-Verbindungskühlrippen 70b. Mit anderen Worten ragen die PCB-Befestigungselemente 75 und die PCB-Verbindungskühlrippen 70b gleich weit vom Gehäuse 40 bzw. von der kartenseitigen Steckseite 34 in Richtung der zweiten Montagerichtung M2 hervor. Wie auch PCB-Verbindungskühlrippen 70b sind auch die PCB-Befestigungselemente 75 vorgesehen und ausgelegt, um mit der PCB-Karte mechanisch und wärmeleitend verbunden zu werden bzw. an der PCB-Karte befestigt, insbesondere angelötet, zu werden. Dazu kann die PCB-Karte (hier nicht gezeigt) entsprechende komplementäre Verbindungselemente, insbesondere geeignete Ausnehmungen oder Löcher, aufweisen. Im montierten Zustand können somit die PCB-Verbindungskühlrippen 70b als auch die PCB-Befestigungselemente 75 mit der PCB-Karte verbunden bzw. mit der PCB-Karte verlötet sein. Auf diese Weise kann eine, insbesondere für Automotive Anwendungen notwendige, Stabilität mit einer Kühl- und Abschirmwirkung erzielt werden.

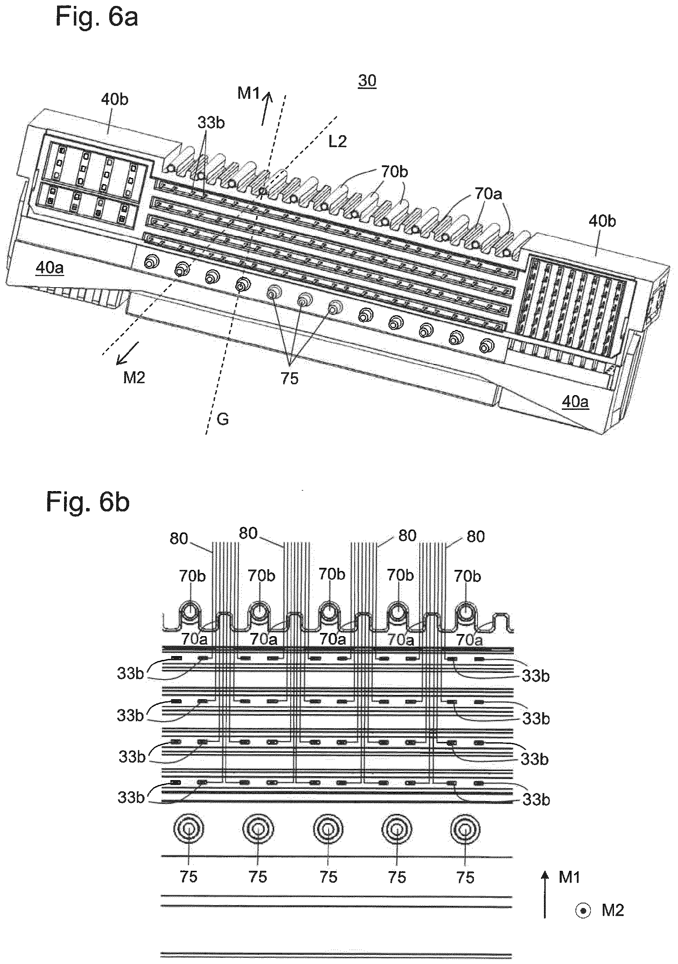

In der **Figur 6a** ist das kartenseitige Verbinderelement 30 der Figur 1 in einer weiteren perspektivischen Ansicht (schräge Untersicht) dargestellt. Zusätzlich ist in dieser Figur die Längsachse L2 einer PCB-Verbindungskühlrippe 70b eingezeichnet, welche sich entlang der zweiten Montagerichtung M2 erstreckt und die Gerade G, welche sich entlang einer Spalte von Differential-Pair Kontaktelementpaaren 33b erstreckt, schneidet.

Die **Figur 6b** zeigt in einer Draufsicht einen vergrößerten Ausschnitt des kartenseitigen Verbinderelements 30, in der anhand einer beispielhaften Anordnung von elektrischen Leiter bzw. Leiterbahnen 80, welche sich insbesondere auf der PCB-Karte befinden können, die vorteilhafte Anordnung der unterschiedlichen Kühlrippen, d.h. der Standardkühlrippen 70a und der PCB-Verbindungskühlrippen 70b veranschaulicht ist. Dadurch, dass zwischen den PCB-Verbindungskühlrippen 70b jeweils eine Standardkühlrippe 70a angeordnet ist, welche nicht mit der PCB-Karte in Eingriff gebracht bzw. verlötet wird, wird eine sogenannte Routinggasse zwischen zwei benachbarten PCB-Verbindungskühlrippen 70b gebildet, in der die Leiterbahnen 80 ungehindert, d.h. ohne von einer Kühlrippe beeinflusst oder gestört zu werden, verlaufen können. Wie in der Figur 6b zu sehen, kann die Routinggasse jeweils zwischen zwei benachbarten Differential-Pair Kontaktelementpaaren 33b des kartenseitigen Verbinderelements 30 gebildet werden. Das Verbindersystem 100 bzw. das kartenseitige Verbinderelement 30 eignet sich somit für die Anforderungen im Automotive-Bereich, da es mit Hilfe der unterschiedlich ausgebildeten Kühlrippen in platzsparender Weise sowohl mechanisch stabil mit einer PCB-Karte verbunden werden kann als auch eine Kühl- und Abschirmfunktion aufweist. Des Weiteren kann mit Hilfe der unterschiedlichen Kühlrippen erster und zweiter Art eine Routinggasse geschaffen werden, mit der die auf der PCB-Karte vorhandenen Leiterbahnen 80 berücksichtigt wird.

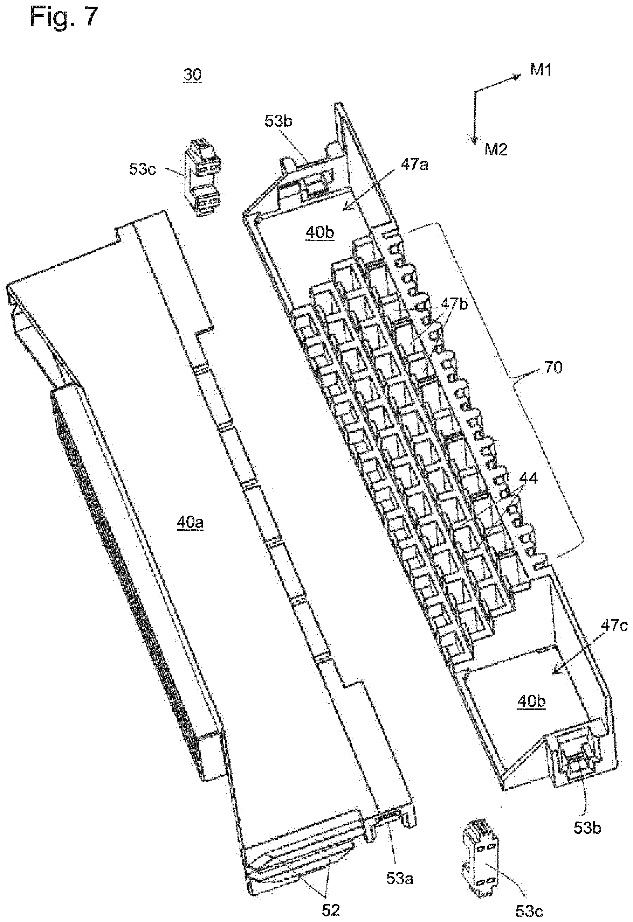

Die **Figur 7** zeigt das kartenseitige Verbinderelement 30 gemäß einer bevorzugten Ausführungsform in einer perspektivischen Explosionsansicht. In dieser Explosionsansicht ist das erste kartenseitige Gehäuseelement 40a und das zweite kartenseitige Gehäuseelement 40b separat, d.h. in einem nicht zusammengesteckten bzw. montierten Zustand gezeigt. Im vollständig montierten Zustand sind das erste kartenseitige Gehäuseelement 40a und das zweite kartenseitige Gehäuseelement 40b miteinander verbunden, d.h. entlang der ersten Montagerichtung M1 zusammengesteckt. Zum Zusammenstecken dient insbesondere ein erstes Fixierelement (Aussparung) 53a des ersten kartenseitigen Gehäuselements 40a und ein zweites Fixierelement (Aussparung) 53b des zweiten kartenseitigen Gehäuselements 40b. Mit Hilfe eines dritten Fixierelements 53c, welches in die Aussparungen 53a und 53b eingreift, können das erste kartenseitige Gehäuseelement 40a und das zweite kartenseitige Gehäuseelement 40b miteinander verbunden bzw. zusammengesteckt werden. Vorzugsweise weist das kartenseitige Verbinderelement 30 jeweils zwei erste Fixierelemente 53a und zwei zweite Fixierelemente 53b auf, welche jeweils mit einem dritten Fixierelement 53c derart verbunden werden können, dass das erste kartenseitige Gehäuseelement 40a und das zweite kartenseitige Gehäuseelement 40b zueinander in Position gehalten werden. Die Führungselemente 52 sind Bestandteile des ersten kartenseitigen Gehäuseelements 40a. In der Figur 7 ist insbesondere eine stufen- oder treppenförmige Anordnung von Gehäuseteilen 44 des zweiten Gehäuseelements 40b erkennbar. Diese Gehäuseteile bilden zweite Differential-Pair-Kontakthohlräume 47b im zweiten kartenseitigen Gehäuseelement 40b aus, welche im montierten Zustand mit zugehörigen ersten Differential-Pair-Kontakthohlräumen (hier nicht explizit gezeigt) des ersten Gehäuseelements 40a verbunden sind. Entsprechend sind im montierten Zustand der zweite Single-End-Kontakthohlraum 47a mit einem ersten Single-End-Kontakthohlraum und der zweite Power-Kontakthohlraum 47c mit einem ersten Power-Kontakthohlraum verbunden. Im montierten Zustand bilden die ersten und zweiten Kontakthohlräume somit die kartenseitigen Kontakthohlräume 31a-31c aus.

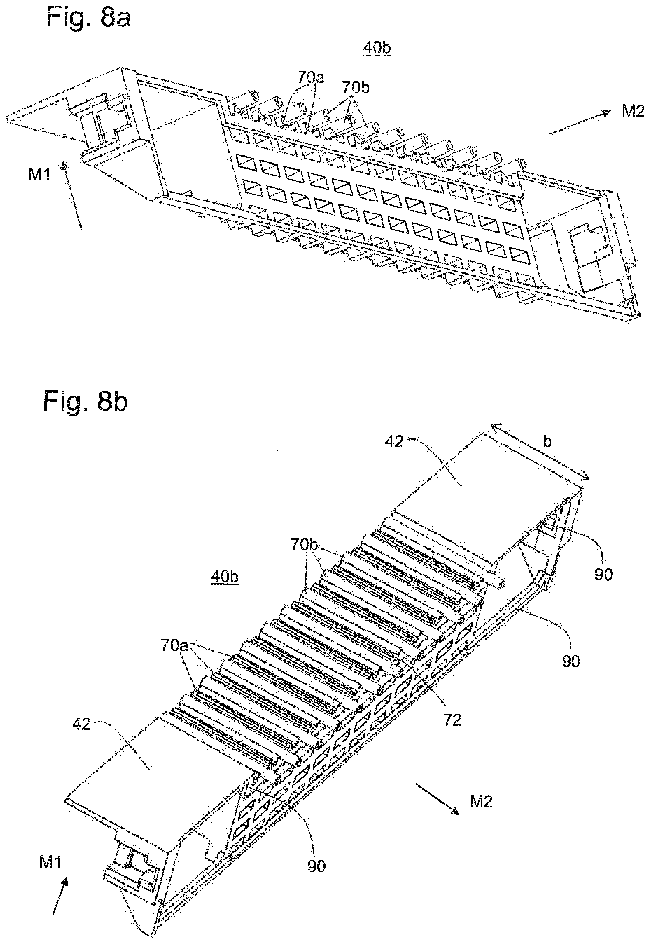

Die **Figuren 8a und 8b** zeigen jeweils in unterschiedlichen perspektivischen Ansichten (jeweils in einer schrägen Untersicht) lediglich das zweite kartenseitige Gehäuseelement 40b des kartenseitigen Verbinderelements 30. In diesen Ansichten ist deutlich zu erkennen, dass die PCB-Verbindungskühlrippen 70b jeweils eine größere Länge aufweisen als die Standardkühlrippen 70a. Während die Länge einer Standardkühlrippe 70a im Wesentlichen der Breite b einer Gehäusewand des zweiten kartenseitigen Gehäuseelements 40b entspricht, so ist die Länge einer PCB-Verbindungskühlrippe 70b größer. Im Gegensatz zu den Standardkühlrippen 70a, deren Endabschnitte jeweils bündig mit einem steckseitigen Rand bzw. einer steckseitigen Fläche 90 des zweiten kartenseitigen Gehäuseelements 40b sind, ragen Endabschnitte 72 der PCB-Verbindungskühlrippen 70b über den steckseitigen Rand bzw. die steckseitige Fläche 90 des zweiten kartenseitigen Gehäuseelements 40b in Richtung der zweiten Montagerichtung M2 hinaus. Der steckseitige Rand 90 des kartenseitgen Gehäuses 40 bzw. des zweiten kartenseitigen Gehäuseelements 40b erstreckt sich senkrecht zur zweiten Montagerichtung M2. Mit anderen Worten ist die steckseitige Fläche 90 des kartenseitgen Gehäuses 40 senkrecht zur zweiten Montagerichtung M2 ausgerichtet. Die erste Montagerichtung M1 liegt in einer Ebene, welche den steckseitigen Rand bzw. die steckseitige Fläche 90 umfasst bzw. welche von dem steckseitigen Rand bzw. der steckseitigen Fläche 90 definiert und/oder aufgespannt wird. Die über den steckseitigen Rand 90 hinausragenden Endabschnitte 72 sind vorgesehen und ausgelegt, um mit der PCB-Karte (nicht gezeigt) verbunden bzw. an dieser befestigt, insbesondere angelötet, zu werden. Im montierten Zustand greifen die hinausragenden Endabschnitte 72 insbesondere in zugehörige Lötstellen bzw. Lötlöcher der PCB-Karte ein und der steckseitige Rand bzw. die steckseitige Fläche 90 des kartenseitigen Gehäuses 40 ist im Wesentlichen bündig zu einem steckseitigen Rand bzw. einer steckseitigen Fläche der PCB-Karte angeordnet.

### Bezugszeichenliste

- 10: rechnerseitiges Verbinderelement
- 11: rechnerseitige Kontakthohlräume
- 11a: rechnerseitiger Single-End Kontakthohlraum
- 11b: rechnerseitiger Differential-Pair Kontakthohlraum
- 11c: rechnerseitiger Power Kontakthohlraum
- 12: rechnerseitiger Isolierkörper/ rechnerseitiges Isolierelement
- 12a: rechnerseitiger Single-End Isolierkörper
- 12b: rechnerseitiger Differential-Pair Isolierkörper
- 12c: rechnerseitiger Power Isolierkörper
- 13: rechnerseitige Kontaktelemente
- 13a: rechnerseitiges Single-End Kontaktelement
- 13b: rechnerseitiges Differential-Pair Kontaktelementpaar
- 13c: rechnerseitiges Power Kontaktelement
- 14: rechnerseitige Steckseite
- 20: rechnerseitiges Gehäuse / Zinkdruckguss-Gehäuse
- 22: Schrauböffnung
- 24a: Stabilisierungselement / Steckhilfe
- 24b: komplementäres Stabilisierungselement / komplementäre Steckhilfe
- 26: Endabschnitt eines rechnerseitigen Kontakthohlraums
- 28a: Eingriffelement / Vorsprung
- 28b: komplementäres Eingriffelement / Öffnung
- 30: kartenseitiges Verbinderelement
- 31: kartenseitige Kontakthohlräume
- 31a: kartenseitiger Single-End Kontakthohlraum
- 31b: kartenseitiger Differential-Pair Kontakthohlraum
- 31c: kartenseitiger Power Kontakthohlraum
- 32: kartenseitiger Isolierkörper / kartenseitiges Isolierelement
- 32a: kartenseitiger Single-End Isolierkörper
- 32b: kartenseitiger Differential-Pair Isolierkörper
- 32c: kartenseitiger Power Isolierkörper
- 33: kartenseitige Kontaktelemente
- 33a: kartenseitiges Single-End Kontaktelement
- 33b: kartenseitiges Differential-Pair Kontaktelementpaar
- 33c: kartenseitiges Power Kontaktelement
- 34: kartenseitige Steckseite
- 40: kartenseitiges Gehäuse / Zinkdruckguss-Gehäuse
- 40a: erstes kartenseitiges Gehäuseelement
- 40b: zweites kartenseitiges Gehäuseelement
- 42: Gehäusewand
- 44: Gehäuseteile
- 47: zweiter kartenseitiger Kontakthohlraum
- 47a: zweiter kartenseitiger Single-End-Kontakthohlraum
- 47b: zweiter kartenseitiger Differential-Pair-Kontakthohlraum
- 47c: zweiter kartenseitiger Power-Kontakthohlraum
- 52: Führungselement
- 53a: erstes Fixierelement (erste Aussparung)
- 53b: zweites Fixierelement (zweite Aussparung)
- 53c: drittes Fixierelement
- 54: komplementäres Führungselement
- 70: Kühlrippen
- 70a: Kühlrippen erster Art / Standardkühlrippen
- 70b: Kühlrippen zweiter Art / PCB-Verbindungskühlrippen
- 72: Endabschnitt einer Kühlrippe zweiter Art
- 75: Verbindungselemente / PCB-Befestigungselemente
- 80: elektrischer Leiter / Leiterbahn
- 90: steckseitiger Rand / steckseitige Fläche
- 100: Verbindersystem
- b: Breite
- G: Gerade
- K: Längsachse des kartenseitigen Verbinderelements
- L: Längsachse einer Kühlrippe erster und/oder zweiter Art
- L2: Längsachse einer Kühlrippe zweiter Art
- M1: erste Montagerichtung
- M2: zweite Montagerichtung
- M: Anzahl an Differential-Pair Kontaktelementpaaren in einer Spalte
- N: Anzahl an Differential-Pair Kontaktelementpaaren in einer Reihe

## Patentansprüche

1. Kartenseitiges Verbinderelement (30) für ein Verbindersystem (100) zum Verbinden einer PCB-Karte mit einem Zentralrechner eines Kraftfahrzeugs, aufweisend ein kartenseitiges Gehäuse (40) mit einer Mehrzahl von Kühlrippen (70), wobei die Mehrzahl von Kühlrippen (70) zumindest eine PCB-Verbindungskühlrippe (70b) aufweist, über die das kartenseitige Gehäuse (40) mit der PCB-Karte mechanisch und wärmeleitfähig verbindbar ist, indem die zumindest eine PCB-Verbindungskühlrippe (70b) einen Endabschnitt (72) aufweist, welcher vorgesehen und ausgelegt ist, um mit der PCB-Karte verbunden zu werden.

2. Verbindersystem (100) zum Verbinden einer PCB-Karte mit einem Zentralrechner eines Kraftfahrzeugs, aufweisend ein rechnerseitiges Verbinderelement (10) und das kartenseitige Verbinderelement (30) nach Anspruch 1.

3. Verbindersystem (100) nach Anspruch 2, wobei die zumindest eine PCB-Verbindungskühlrippe (70b) über einen steckseitigen Rand (90) des kartenseitigen Gehäuses (40) hinausragt.

4. Verbindersystem (100) nach Anspruch 2 oder 3, wobei die Kühlrippen (70) derart angeordnet sind, dass jeweils eine Längsachse (L) der Kühlrippen (70) senkrecht zu einer Längsachse (K) des kartenseitigen Verbinderelements (30) ausgerichtet ist.

5. Verbindersystem (100) nach einem der Ansprüche 2 bis 4, wobei die Mehrzahl von Kühlrippen (70) zumindest eine Kühlrippe erster Art (70a) und zumindest eine Kühlrippe zweiter Art, welche der zumindest einen PCB-Verbindungskühlrippe (70b) entspricht, umfasst, und wobei vorzugsweise die Kühlrippe zweiter Art (70b) im Vergleich zur Kühlrippe erster Art (70a) eine größere Länge aufweist.

6. Verbindersystem (100) nach Anspruch 5, wobei das kartenseitige Gehäuse (40) zumindest zwei Kühlrippen zweiter Art (70b) aufweist und zwischen zwei benachbarten Kühlrippen zweiter Art (70b) jeweils eine der zumindest einen Kühlrippe erster Art (70a) angeordnet ist.

7. Verbindersystem (100) nach einem der Ansprüche 2 bis 6, wobei
das kartenseitige Verbinderelement (30) eine Anzahl N von in einer Reihe angeordneten kartenseitigen Differential-Pair Kontaktelementpaaren (33b) aufweist und wobei die Anzahl an PCB-Verbindungskühlrippen (70b) der Anzahl N entspricht.

8. Verbindersystem (100) nach einem der Ansprüche 2 bis 7, wobei das rechnerseitige Verbinderelement (10) ausgelegt ist, um entlang einer ersten Montagerichtung (M1) mit dem Zentralrechner verbunden zu werden, wobei das kartenseitige Verbinderelement (30) ausgelegt ist, um entlang einer zweiten Montagerichtung (M2) mit der PCB-Karte verbunden zu werden, und wobei das rechnerseitige Verbinderelement (10) und das kartenseitige Verbinderelement (30) entlang der ersten Montagerichtung (M1) zusammensteckbar sind.

9. Verbindersystem (100) nach einem der Ansprüche 2 bis 8, wobei die Kühlrippen (70) derart angeordnet sind, dass jeweils eine Längsachse (L) der Kühlrippen (70) entlang der zweiten Montagerichtung (M2) ausgerichtet ist.

10. Verbindersystem (100) nach einem der Ansprüche 2 bis 9, wobei die zumindest eine PCB-Verbindungskühlrippe (70b) derart angeordnet ist, dass eine Längsachse (L2) dieser Kühlrippe (70b) eine Gerade (G) schneidet, welche sich zwischen den Kontaktelementen eines Differential-Pair Kontaktelementpaares (33b) des kartenseitigen Verbinderelements (30) befindet und entlang der ersten Montagerichtung (M1) ausgerichtet ist.

11. Verbindersystem (100) nach einem der Ansprüche 2 bis 10, wobei das kartenseitige Gehäuse (40) zweiteilig ausgebildet ist.

12. Verbindersystem (100) nach einem der Ansprüche 2 bis 11, wobei das kartenseitige Gehäuse (40) ein erstes kartenseitiges Gehäuseelement (40a) mit einem ersten Fixierelement (53a) und ein zweites kartenseitiges Gehäuseelement (40b) mit einem zweiten Fixierelement (53b) aufweist, und wobei vorzugsweise das erste kartenseitige Gehäuseelement (40a) und das zweite kartenseitige Gehäuseelement (40b) mit Hilfe eines dritten Fixierelements (53c) zueinander in Position gehalten werden können, indem das dritte Fixierelement (53c) in das erste Fixierelement (53a) und in das zweite Fixierelement (53b) eingreift.

13. Verbindersystem (100) nach einem der Ansprüche 2 bis 12, wobei das kartenseitige Gehäuse (40) ein erstes kartenseitiges Gehäuseelement (40a) und ein zweites kartenseitiges Gehäuseelement (40b) aufweist, wobei das erste kartenseitige Gehäuseelement (40a) zumindest ein Führungselement (52) aufweist, welches mit einem komplementären Führungselement (54) des rechnerseitigen Verbinderelements (10) in Eingriff gebracht werden kann, und wobei das zweite kartenseitige Gehäuseelement (40b) die Kühlrippen (70) aufweist.

14. Verbindersystem (100) nach einem der Ansprüche 2 bis 13,
wobei das Verbindersystem (100) ferner die PCB-Karte aufweist, und wobei
die die zumindest eine PCB-Verbindungskühlrippe (70b) im montierten Zustand mit der PCB-Karte verbunden ist und/oder an die PCB-Karte befestigt, insbesondere verlötet, ist.

15. Verbindersystem (100) nach einem der Ansprüche 2 bis 14, wobei das rechnerseitige Verbinderelement (10) aufweist:
- ein rechnerseitiges Gehäuse (20) mit zumindest einem rechnerseitigen Kontakthohlraum (11a-11c);
- zumindest einen rechnerseitigen Isolierkörper (12a-12c), welcher im montierten Zustand innerhalb des zumindest einen rechnerseitigen Kontakthohlraums (11a-11c) angeordnet ist;
- eine Vielzahl von rechnerseitigen Kontaktelementen (13a-13c), welche im montierten Zustand zumindest bereichsweise innerhalb von rechnerseitigen Isolierhohlräumen in dem zumindest einen rechnerseitigen Isolierkörper (12a-12c) angeordnet sind;
und wobei
das kartenseitige Verbinderelement (30) aufweist:
- das kartenseitige Gehäuse (40) mit zumindest einem kartenseitigen Kontakthohlraum (31a-31c);
- zumindest einen kartenseitigen Isolierkörper (32a-32c), welcher im montierten Zustand innerhalb des zumindest einen kartenseitigen Kontakthohlraums (31a-31c) angeordnet ist und kartenseitige Isolierhohlräume aufweist, die ausgelegt sind, um im montierten Zustand die rechnerseitigen Kontaktelemente (13a-13c) zumindest bereichsweise aufzunehmen;
- eine Vielzahl von kartenseitigen Kontaktelementen (33a-33c), welche im montierten Zustand zumindest bereichsweise innerhalb der kartenseitigen Isolierhohlräume angeordnet sind und die rechnerseitigen Kontaktelemente (13a-13c) elektrisch kontaktieren; und
wobei vorzugsweise das kartenseitige und rechnerseitige Gehäuse (20, 40) aus Zinkdruckguss gebildet sind.

## Claims

1. A card-side connector element (30) for a connector system (100) for connecting a PCB card to a central computer of a motor vehicle, comprising a card-side housing (40) having a plurality of cooling ribs (70), wherein the plurality of cooling ribs (70) comprises at least one PCB connection cooling rib (70b), via which the card-side housing (40) can be mechanically connected to the PCB card so as to conduct heat in that the at least one PCB connection cooling rib (70b) comprises an end portion (72) that is intended and designed to be connected to the PCB card.

2. A connector system (100) for connecting a PCB card to a central computer of a motor vehicle, comprising a computer-side connector element (10) and the card-side connector element (30) according to claim 1.

3. The connector system (100) according to claim 2, wherein the at least one PCB connection cooling rib (70b) projects beyond a plug-in-side edge (90) of the card-side housing (40).

4. The connector system (100) according to claim 2 or 3, wherein the cooling ribs (70) are arranged such that a longitudinal axis (L) of the cooling ribs (70) is in each case oriented perpendicularly to a longitudinal axis (K) of the card-side connector element (30).

5. The connector system (100) according to any one of claims 2 to 4, wherein the plurality of cooling ribs (70) comprises at least one cooling rib of a first type (70a) and at least one cooling rib of a second type, which corresponds to the at least one PCB connection cooling rib (70b), and wherein the cooling rib of the second type (70b) preferably has a greater length compared to the cooling rib of the first type (70a).

6. The connector system (100) according to claim 5, wherein the card-side housing (40) comprises at least two cooling ribs of the second type (70b) and one of the at least one cooling ribs of the first type (70a) is in each case arranged between two adjacent cooling ribs of the second type (70b).

7. The connector system (100) according to any one of claims 2 to 6, wherein the card-side connector element (30) comprises a number N of card-side differential pair contact elements (33b) arranged in a row and wherein the number of PBC connection cooling ribs (70b) corresponds to the number N.

8. The connector system (100) according to any one of claims 2 to 7, wherein the computer-side connector element (10) is designed to be connected to the central computer in a first assembly direction (M1), wherein the card-side connector element (30) is designed to be connected to the PCB card in a second assembly direction (M2), and wherein the computer-side connector element (10) and the card-side connector element (30) can be plugged together in the first assembly direction (M1).

9. The connector system (100) according to any one of claims 2 to 8, wherein the cooling ribs (70) are arranged such that a longitudinal axis (L) of the cooling ribs (70) is in each case oriented in the second assembly direction (M2).

10. The connector system (100) according to any one of claims 2 to 9, wherein the at least one PCB connection cooling rib (70b) is arranged such that a longitudinal axis (L2) of said cooling rib (70b) intersects a straight line (G) that is located between the contact elements of a differential pair contact element pair (33b) of the card-side connector element (30) and that is oriented in the first assembly direction (M1).

11. The connector system (100) according to any one of claims 2 to 10, wherein the card-side housing (40) is formed of two parts.

12. The connector system (100) according to any one of claims 2 to 11, wherein the card-side housing (40) comprises a first card-side housing element (40a) having a first securing element (53a) and a second card-side housing element (40b) having a second securing element (53b), and wherein the first card-side housing element (40a) and the second card-side housing element (40b) can preferably be held in position relative to one another by means of a third securing element (53c) in that the third securing element (53c) engages in the first securing element (53a) and in the second securing element (53b).

13. The connector system (100) according to any one of claims 2 to 12, wherein the card-side housing (40) comprises a first card-side housing element (40a) and a second card-side housing element (40b), wherein the first card-side housing element (40a) comprises at least one guide element (52), which can be brought into engagement with a complementary guide element (54) of the computer-side connector element (10), and wherein the second card-side housing element (40b) comprises the cooling ribs (70).

14. The connector system (100) according to any one of claims 2 to 13, wherein the connector system (100) further comprises the PCB card, and wherein, in the assembled state, the at least one PCB connection cooling rib (70b) is connected to the PCB card and/or fastened to the PCB card, in particular soldered.

15. The connector system (100) according to any one of claims 2 to 14, wherein the computer-side connector element (10) comprises:
- a computer-side housing (20) having at least one computer-side contact cavity (11a-11c);
- at least one computer-side insulating body (12a-12c), which, in the assembled state, is arranged inside the at least one computer-side contact cavity (11a-11c);
- a large number of computer-side contact elements (13a-13c), which, in the assembled state, are arranged at least in regions inside computer-side insulating cavities in the at least one computer-side insulating body (12a-12c);
and wherein
the card-side connector element (30) comprises:
- the card-side housing (40) having at least one card-side contact cavity (31a-31c);
- at least one card-side insulating body (32a-32c), which, in the assembled state, is arranged inside the at least one card-side contact cavity (31a-31c) and comprises card-side insulating cavities that are designed to receive the computer-side contact elements (13a-13c) at least in regions in the assembled state;
- a large number of card-side contact elements (33a-33), which, in the assembled state, are arranged at least in regions inside the card-side insulating cavities and electrically contact the computer-side contact elements (13a-13c); and
wherein the card-side and computer-side housings (20, 40) are preferably formed from zinc diecasting.

## Revendications

1. Élément connecteur du côté de la carte (30) destiné à un système de connecteur (100) servant à relier une carte de circuit imprimé à un calculateur central d'un véhicule à moteur, présentant un boîtier du côté de la carte (40) avec de multiples ailettes de refroidissement (70), dans lequel les multiples ailettes de refroidissement (70) comportent au moins une ailette de refroidissement connectée à la carte de circuit imprimé (70b), par l'intermédiaire de laquelle le boîtier du côté de la carte (40) peut être relié mécaniquement et de façon thermoconductrice à la carte de circuit imprimé, du fait que ladite ailette de refroidissement au moins connectée à la carte de circuit imprimé (70b) présente une partie terminale (72), laquelle est prévue et conçue pour être reliée à la carte de circuit imprimé.

2. Système de connecteur (100) servant à relier une carte de circuit imprimé à un calculateur central d'un véhicule à moteur, présentant un élément connecteur du côté du calculateur (10) et l'élément connecteur du côté de la carte (30) selon la revendication 1.

3. Système de connecteur (100) selon la revendication 2, dans lequel ladite ailette de refroidissement au moins connectée à la carte de circuit imprimé (70b) dépasse d'un bord du côté enfichable (90) du boîtier du côté de la carte (40).

4. Système de connecteur (100) selon la revendication 2 ou 3, dans lequel les ailettes de refroidissement (70) sont disposées de sorte qu'un axe longitudinal (L) des ailettes de refroidissement (70) est orienté respectivement à la perpendiculaire d'un axe longitudinal (K) de l'élément connecteur du côté de la carte (30).

5. Système de connecteur (100) selon l'une des revendications 2 à 4, dans lequel les multiples ailettes de refroidissement (70) comprennent au moins une ailette de refroidissement du premier type (70a) et au moins une ailette de refroidissement du second type, laquelle correspond à ladite ailette de refroidissement au moins connectée à la carte de circuit imprimé (70b), et dans lequel l'ailette de refroidissement du second type (70b) présente de préférence une longueur supérieure à l'ailette de refroidissement du premier type (70a).

6. Système de connecteur (100) selon la revendication 5, dans lequel le boîtier du côté de la carte (40) présente au moins deux ailettes de refroidissement du second type (70b) et l'une de ladite ailette de refroidissement du premier type (70a) au moins est disposée respectivement entre deux ailettes de refroidissement adjacentes du second type (70b).

7. Système de connecteur (100) selon l'une des revendications 2 à 6, dans lequel l'élément connecteur du côté de la carte (30) présente un nombre N de paires d'éléments de contact par paire différentielle du côté de la carte (33b) disposées en série et dans lequel le nombre d'ailettes de refroidissement connectées à la carte de circuit imprimé (70b) correspond au nombre N.

8. Système de connecteur (100) selon l'une des revendications 2 à 7, dans lequel l'élément connecteur du côté du calculateur (10) est conçu pour être relié au calculateur central suivant un premier sens de montage (M1), dans lequel l'élément connecteur du côté de la carte (30) est conçu pour être relié à la carte de circuit imprimé suivant un second sens de montage (M2), et dans lequel l'élément connecteur du côté du calculateur (10) et l'élément connecteur du côté de la carte (30) peuvent être assemblés suivant le premier sens de montage (M1).

9. Système de connecteur (100) selon l'une des revendications 2 à 8, dans lequel les ailettes de refroidissement (70) sont disposées de sorte qu'un axe longitudinal (L) des ailettes de refroidissement (70) est orienté respectivement dans le second sens de montage (M2).

10. Système de connecteur (100) selon l'une des revendications 2 à 9, dans lequel ladite ailette de refroidissement au moins connectée à la carte de circuit imprimé (70b) est disposée de sorte qu'un axe longitudinal (L2) de cette ailette de refroidissement (70b) coupe une droite (G), laquelle se trouve entre les éléments de contact d'une paire d'éléments de contact par paire différentielle (33b) de l'élément connecteur du côté de la carte (30) et est orienté dans le premier sens de montage (M1).

11. Système de connecteur (100) selon l'une des revendications 2 à 10, dans lequel le boîtier du côté de la carte (40) est constitué de deux parties.

12. Système de connecteur (100) selon l'une des revendications 2 à 11, dans lequel le boîtier du côté de la carte (40) présente un premier élément de boîtier du côté de la carte (40a) avec un premier élément de fixation (53a) et un second élément de boîtier du côté de la carte (40b) avec un deuxième élément de fixation (53b), et dans lequel de préférence le premier élément de boîtier du côté de la carte (40a) et le second élément de boîtier du côté de la carte (40b) peuvent être maintenus en position l'un par rapport à l'autre à l'aide d'un troisième élément de fixation (53c), du fait que le troisième élément de fixation (53c) s'engage dans le premier élément de fixation (53a) et dans le deuxième élément de fixation (53b).

13. Système de connecteur (100) selon l'une des revendications 2 à 12, dans lequel le boîtier du côté de la carte (40) présente un premier élément de boîtier du côté de la carte (40a) et un second élément de boîtier du côté de la carte (40b), dans lequel le premier élément de boîtier du côté de la carte (40a) présente au moins un élément de guidage (52), lequel peut être mis en prise avec un élément de guidage complémentaire (54) de l'élément connecteur du côté du calculateur (10), et dans lequel le second élément de boîtier du côté de la carte (40b) comporte les ailettes de refroidissement (70).

14. Système de connecteur (100) selon l'une des revendications 2 à 13, dans lequel le système de connecteur (100) présente encore la carte de circuit imprimé, et dans lequel ladite ailette de refroidissement au moins connectée à la carte de circuit imprimé (70b) est reliée à la carte de circuit imprimé et / ou fixée à la carte de circuit imprimé, notamment y est soudée, dans un état monté.

15. Système de connecteur (100) selon l'une des revendications 2 à 14, dans lequel l'élément connecteur du côté du calculateur (10) présente :
- un boîtier du côté du calculateur (20) avec au moins une cavité de contact du côté du calculateur (11a-11c) ;
- au moins un corps isolant du côté du calculateur (12a-12c), lequel est disposé à l'intérieur de ladite cavité de contact au moins du côté du calculateur (11a-11c) dans un état monté;
- de multiples éléments de contact du côté du calculateur (13a-13c), lesquels sont disposés au moins par endroits à l'intérieur des cavités isolantes du côté du calculateur au sein dudit corps isolant au moins du côté du calculateur (12a-12c) dans un état monté;
et dans lequel
l'élément connecteur du côté de la carte (30) présente :
- le boîtier du côté de la carte (40) avec au moins une cavité de contact du côté de la carte (31a-31c) ;
- au moins un corps isolant du côté de la carte (32a-32c), lequel est disposé à l'intérieur de ladite cavité de contact au moins du côté de la carte (31a-31c) dans un état monté et présente des cavités isolantes du côté de la carte, qui sont conçues pour recevoir au moins par endroits les éléments de contact du côté du calculateur (13a-13c) dans un état monté ;
- de multiples éléments de contact du côté de la carte (33a-33c), lesquels sont disposés au moins par endroits à l'intérieur des cavités isolantes du côté de la carte et contactent électriquement les éléments de contact du côté du calculateur (13a-13c) dans un état monté; et
dans lequel les boîtiers du côté du calculateur et du côté de la carte (20, 40) sont constitués de préférence à base de zinc coulé sous pression.
